# EUROPÄISCHE PATENTSCHRIFT

(11) **EP 4 179 555 B1**
(45) Veröffentlichungstag und Bekanntmachung des Hinweises auf die Patenterteilung: **29.01.2025**
(21) Anmeldenummer: 21754890.8
(22) Anmeldetag: 07.07.2021
(51) Int. Cl.: H01F 37/00, H05K 9/00

(54) **HVDC-LUFTDROSSELSPULE**
HVDC AIR-CORE REACTOR
BOBINE À NOYAU D'AIR CCHT

(30) Priorität: 07.07.2020 AT 505802020
(43) Veröffentlichungstag der Anmeldung: 17.05.2023
(73) Patentinhaber: Coil Holding GmbH, 4070 Eferding (AT)
(72) Erfinder: EDER, Josef, 4150 Rohrbach (AT); FRÖHLICH, Bernhard, 4073 Wilhering (AT); SCHUSTER, Rainer, 4150 Rohrbach-Berg (AT)
(74) Vertreter: Burger, Hannes
(86) Internationale Anmeldenummer: PCT/AT2021/060243
(87) Internationale Veröffentlichungsnummer: WO 2022/006610

(56) Entgegenhaltungen:
- WO-A1-2009/126977
- WO-A1-2017/182577
- JP-A- S5 279 257
- REISINGER H ET AL: "Innovative mitigation measures for electrostatic charge build-up on surfaces of dry-type air-core reactors for HVDC application", ELEKTROTECHNIK UND INFORMATIONSTECHNIK, SPRINGER VERLAG, WIEN, AT, vol. 135, no. 8, 22 November 2018 (2018-11-22), pages 563 - 566, XP036657908, ISSN: 0932-383X, [retrieved on 20181122], DOI: 10.1007/S00502-018-0662-Z

## Beschreibung

Die Erfindung betrifft eine HVDC-Drosselspule, insbesondere eine Luftkern-Drosselspule für den Mittel-, Hoch- und Höchstspannungsbereich in Energieversorgungsnetzen, mit Maßnahmen zur Unterdrückung von feldstärkebedingten Partikelablagerungen an der Oberfläche der HVDC-Drosselspule, sowie ein Verfahren zur Herstellung einer entsprechenden HVDC-Drosselspule.

Vor allem bei Drosselspulen welche im Freien installiert werden und welche in Höchst- oder Hochvolt-Gleichspannungsbereichen (HVDC-Bereiche), oder auch in Gleichstrom-Mittelspannungsabschnitten von elektrischen Energieversorgungsnetzen implementiert sind, kann es aufgrund des hohen elektrischen Gleichfeldes solcher Drosselspulen zu unerwünschten, dauerhaften Partikelansammlungen bzw. zu einer allmählichen Akkumulierung von Schmutzpartikeln an der Oberfläche dieser Drosselspulen kommen. Dies wird typischerweise noch verstärkt, wenn die Drosselspulen in einer Umgebung mit hoher Schmutzbelastung installiert werden. Dies verursacht sogenannte "Black Spots" an den Oberflächen solcher Drosselspulen. Dieser allmähliche Verschmutzungsvorgang an Höchst- oder Hochspannungs-Drosselspulen, oder auch an Mittelspannungs-Drosselspulen, wird in Fachkreisen auch als "Black Spot Phenomenon" bezeichnet.

Die Oberflächenschicht dieser Drosselspulen weist standardmäßig ein möglichst hohes elektrisches Isolationsvermögen auf. Aus einer anfänglich rein optischen Beeinträchtigung der elektrisch sehr gut isolierenden Oberfläche solcher Drosselspulen kann mit zunehmender Flächendichte und Schichtdicke der vorgenannten Verunreinigungen, welche sich typischerweise punktförmig ausbilden, auch eine technische bzw. elektrische Beeinträchtigung werden. Im schlechtesten Fall kann die Isolationswirkung der Isolationsschicht, insbesondere der Kunststoff-Isolation an der Wicklungsoberfläche der Drosselspule, beeinträchtigt und somit das elektrische Verhalten der Drosselspule nachteilig beeinflusst werden. Es kann dadurch zu unerwünschten bzw. undefinierten Kriechströmen und im Extremfall sogar zu einem Isolationsversagen und zu Kurzschlüssen innerhalb der Drosselspule kommen.

Um solche ladungsbedingten Verunreinigungen der Drosselspule hintan zu halten ist es aus physikalischer Sicht erforderlich, den Aufbau von elektrischen Ladungen während des Betriebs der Drosselspule in oder auf der zumindest einen Isolationsschicht an der Wicklungsoberfläche der Drosselspule bestmöglich zu vermeiden oder zu reduzieren. Hierzu ist die elektrische Isolationsschicht der Drosselspule zumindest partiell mit einer Ladungsableitungsschicht zu versehen, welche Ladungsableitungsschicht aus elektrisch dissipativem Material besteht. Dieses elektrisch dissipative Material weist eine vorbestimmte elektrische Leitfähigkeit auf, um so einen Aufbau von hohen elektrischen Ladungen, insbesondere von erhöhten elektrostatischen Aufladungen, an der Isolations-Oberfläche der Drosselspule zu hemmen. Die elektrische Leitfähigkeit der Ladungsableitungssicht bzw. dessen elektrisch dissipatives Material ist derart gewählt, dass die maximal auftretenden Ladungsintensitäten an der Wicklungsoberfläche der Drosselspule unter einem vorbestimmten Wert bleiben.

In der WO2009/126977A1 wird in Zusammenhang mit einer Verminderung elektrostatisch bedingter Verschmutzungen von HVDC-Luftdrosselspulen vorgeschlagen, eine elektrostatische Abschirmung an der äußeren Mantelfläche der Drosselspule anzubringen. Diese elektrostatische Abschirmung ist durch einen hohlzylindrischen Mantel für die Drosselspule gebildet, welcher hohlzylindrische Mantel an zumindest einem seiner axialen Enden mit einer gesonderten, im Wesentlichen über den Umfang des hohlzylindrischen Mantels verlaufenden, ringförmigen Kollektorelektrode versehen ist, welche Kollektorelektrode zum Anschluss an einen der elektrischen Anschlüsse der Luftdrosselspule vorgesehen ist. Der hohlzylindrische Mantel ist aus einer Folie aus elektrostatisch dissipativem Material mit einem Oberflächenwiderstand im Bereich von 10⁹ bis 10¹⁴ Ohm/Quadrat gefertigt. Dieser Aufbau ist nur bedingt zufriedenstellend, weil er schwierig herzustellen ist bzw. weil er für jeweils unterschiedliche Geometrien oder Abmessungen von Drosselspulen individuell angefertigte Abschirmungen erfordert. Aufgrund komplexer Fertigungsabläufe entstehen auch erhöhte Produktionskosten für solche HVDC-Luftdrosselspulen.

Demzufolge wurde gemäß der WO2017/182577A1 eine HVDC-Luftdrosselspule vorgeschlagen, bei der die elektrostatische Abschirmung ebenso eine Schicht aus elektrostatisch dissipativem Material enthält und welche Schicht an zumindest einem Ende mit einer im Wesentlichen über den Umfang der Luftdrosselspule verlaufenden, ringförmigen Kollektorelektrode zum Anschluss an einen der Anschlüsse der Luftdrosselspule versehen ist. Hierbei ist diese Schicht aber als Sprühbeschichtung ausgebildet, welche Sprühbeschichtung an einer Mantelfläche einer außenliegenden Wicklungslage der Luftdrosselspule aufgebracht ist. Derartige Sprühbeschichtungen erfordern hinsichtlich Umweltverträglichkeit bzw. niedriger Verarbeitungsemissionen erhöhten technischen Aufwand. Zudem ist es bei der Aufbringung einer solchen Sprühbeschichtung schwierig, eine möglichst gleichmäßige und lückenlose bzw. ausreichend starke Schichtdicke herzustellen.

REISINGER H ET AL, "Innovative mitigation measures for electrostatic charge build-up on surfaces of dry-type air-core reactors for HVDC application", ELEKTROTECHNIK UND INFORMATIONSTECHNIK, SPRINGER VERLAG, WIEN, AT, Vol. 135, No. 8, 22. November 18, Seiten 563-566, offenbart eine HVDC-Luftdrosselspule entsprechend dem einleitenden Teil von Anspruch 1. Deren Ladungsableitungsschicht ist als polymerer Film oder als polymere Sprühbeschichtung ausgeführt.

Die JP S52-79257 A offenbart ein Verfahren zur Bildung einer porösen Schicht innerhalb einer feldentspannenden Schicht mit einer Hohlraumschicht, insbesondere durch Bereitstellung einer feldentspannenden Schicht innerhalb der Isolierschicht, die eine halbleitende oder leitende Schicht ist. Eine leitende oder halbleitende feldentspannende Schicht ist dazu in der Isolierschicht und eine Leerraumschicht in der feldentspannenden Schicht bzw. eine isolierende Folie mit hervorragenden elektrischen und mechanischen Eigenschaften vorgesehen. Damit sollen Schäden wie beispielsweise Rissbildung in der Außenhülle zum Beispiel einer Spule vermieden werden können, die aufgrund der unterschiedlichen Wärmeausdehnungskoeffizienten von Metall- und Kunststoffteilen des elektrischen Bauteils und daraus entstehende Spannungen in der Außenhülle entstehen. Eine Vermeidung von Partikelablagerungen wird nicht behandelt.

Wenn im Nachfolgenden die Kurzbezeichnung HVDC-Luftdrosselspule oder Luftdrosselspule verwendet wird, so sind darunter Luftdrosselspulen für Gleichspannungen im Höchst-, Hoch- und Mittelspannungsbereich zu verstehen.

Aufgabe der vorliegenden Erfindung war es, die Nachteile des Standes der Technik zu überwinden und eine HVDC-Luftdrosselspule zur Verfügung zu stellen, an welcher unerwünschte, feldstärkebedingte Partikelablagerungen während des aktiven Betriebs vermindert werden können und welche HVDC-Luftdrosselspule dennoch möglichst wirtschaftlich und funktionszuverlässig aufgebaut werden kann und dabei auch prozessstabil hergestellt werden kann.

Diese Aufgabe wird durch eine HVDC-Luftdrosselspule und durch ein Herstellungsverfahren gemäß den Ansprüchen gelöst.

Die erfindungsgemäße HVDC-Luftdrosselspule umfasst einen im wesentlichen hohlzylindrischen Wicklungskörper mit zumindest einer hohlzylindrischen Wicklungslage und weist eine zentrale Spulenachse und zumindest zwei elektrische Anschlüsse auf. Die zumindest eine hohlzylindrische Wicklungslage der Luftdrosselspule umfasst einen elektrischen Leiterdraht, welcher elektrische Leiterdraht mitsamt seiner mantelseitigen Isolationsschicht, also mitsamt seiner Mantelisolierung, wendelförmig um die Spulenachse gewickelt ist. Vorzugsweise liegen die einzelnen Windungen der zumindest einen Wicklungslage in Bezug auf die Axialrichtung der zumindest einen hohlzylindrischen Wicklungslage unmittelbar aufeinander bzw. übereinander und bilden so jeweils in sich geschlossene, radial innere und äußere Mantelflächen der zumindest einen hohlzylindrischen Wicklungslage aus. Zudem ist eine Ladungsableitungsschicht mit einer vorbestimmten elektrischen Leitfähigkeit ausgebildet, welche Ladungsableitungsschicht zumindest an der radial äußeren Mantelfläche der zumindest einen hohlzylindrischen Wicklungslage angebracht ist und mit wenigstens einem der elektrischen Anschlüsse der Luftdrosselspule elektrisch leitfähig verbunden ist, vorzugsweise zu der zumindest einen hohlzylindrischen Wicklungslage elektrisch parallel geschaltet ist. Die Ladungsableitungsschicht umfasst dabei zumindest ein erstes Bandelement aus elektrisch leitfähigem Material, welches zumindest eine erste Bandelement wendelförmig um die Spulenachse verläuft und an der äußeren Mantelfläche der zumindest einen hohlzylindrischen Wicklungslage anliegt, insbesondere wendelförmig um eine radial äußere Wicklungsisolation der zumindest einen hohlzylindrischen Wicklungslage gewickelt ist und direkt bzw. luftspaltfrei daran anliegt. Das zumindest eine erste Bandelement weist eine vorbestimmte elektrische Leitfähigkeit auf, welche geringer ist als eine elektrische Leitfähigkeit des elektrischen Leiterdrahtes, jedoch höher ist als eine elektrische Leitfähigkeit der mantelseitigen Isolationsschicht des Leiterdrahtes.

Ein Vorteil der erfindungsgemäßen HVDC-Luftdrosselspule liegt darin, dass eine optimale Ladungsableitung zu wenigstens einem der beiden axialen Stirnenden der Wicklungslage erreicht werden kann und so eine allmähliche Ausbildung von betriebsbedingten, punktförmigen Verunreinigungen der Wicklungsoberflächen hintan gehalten werden kann. Insbesondere kann dadurch eine plangemäße Ladungsableitungsschicht mit zuverlässiger Wirkungsweise gewährleistet werden. Aufgrund einer zuverlässig reproduzierbaren, hohen Genauigkeit und Funktionszuverlässigkeit dieser Konstruktion kann auch eine verbesserte Robustheit und ein langfristig hohes Qualitätsniveau der Ladungsableitungsschicht erreicht werden. Darüber hinaus ermöglicht ein solcher Aufbau der HVDC-Luftdrosselspule eine kosteneffiziente bzw. rasche Herstellbarkeit. Insbesondere kann ein relativ prozesssicherer Produktionsablauf geschaffen werden, welcher die Herstellung qualitativ hochwertiger HVDC-Drosselspulen unterstützt.

Des Weiteren kann es zweckmäßig sein, wenn die Ladungsableitungsschicht zumindest ein zweites Bandelement aus elektrisch leitfähigem Material umfasst, welches zumindest eine zweite Bandelement in Axialrichtung der Luftdrosselspule zumindest an der äußeren Mantelfläche bzw. im unmittelbaren Bereich der äußeren Mantelfläche der zumindest einen Wicklungslage verläuft, wobei das zumindest eine erste Bandelement und das zumindest eine zweite Bandelement an mehreren Überkreuzungsstellen einander überkreuzend verlaufen und an diesen Überkreuzungsstellen miteinander kontaktiert sind, insbesondere elektrisch leitfähig miteinander verbunden sind. Zweckmäßig ist es dabei, wenn wenigstens zumindest zwei, vorzugsweise drei oder mehr über den Umfang der Wicklungslage verteilt angeordnete, axial verlaufende, zweite Bandelemente vorgesehen sind. Unter Axialrichtung ist ein Verlauf parallel zur Spulenachse zu verstehen. Dadurch können elektrische Ladungen auf kurzem Weg in Richtung zu dem wenigstens einen zweiten Bandelement transportiert werden und via das zumindest eine zweite Bandelement zu einem der elektrischen Anschlüsse der Luftdrosselspule, insbesondere zu Sternarmen eines allfälligen Wicklungssterns der Luftdrosselspule, abgeführt werden. Insbesondere können so definierte bzw. möglichst zuverlässige Ableitungspfade zur Vermeidung oder Reduzierung elektrostatischer Aufladungen der Drosselspulen-Mantelfläche bzw. der Wicklungslagenisolation aufgebaut werden. Die entsprechende Konstruktion ist dabei besonders funktionszuverlässig und ausfallssicher, weil einzelne Kontaktstellen mit einem erhöhten Übergangswiderstand, beispielsweise aufgrund von Temperaturveränderungen bzw. temperaturbedingten Ausgleichsbewegungen, nicht zu einem Versagen führen können bzw. kaum eine Beeinträchtigung der plangemäßen Funktion der Ladungsableitungsschicht verursachen können.

Die Luftdrosselspule kann ferner einen ersten elektrisch leitfähigen Wicklungsstern umfassen, welcher an einem ersten axialen Stirnende der zumindest einen hohlzylindrischen Wicklungslage angeordnet ist, und einen zweiten elektrisch leitfähigen Wicklungsstern umfassen, welcher an einem zweiten axialen Stirnende der zumindest einen hohlzylindrischen Wicklungslage angeordnet ist. Dabei kann vorgesehen sein, dass das wenigstens eine zweite, axial zur Luftdrosselspule verlaufende Bandelement aus dem elektrisch leitfähigen Material den ersten und zweiten Wicklungsstern mit einer vorbestimmten elektrischen Leitfähigkeit miteinander verbindet. Analoges gilt dann, wenn anstelle solcher Wicklungssterne an jedem der axialen Stirnenden der Luftdrosselspule baulich jeweils eigenständige, radial vergleichsweise kürzere, erste bzw. zweite Sternarmelemente ausgebildet sind. Ein Vorteil dieser baulichen Maßnahme liegt darin, dass keine gesonderten Verbindungsdrähte bzw. Drahtbrücken oder Verbindungsschlaufen zwischen der Ladungsableitungsschicht und dem wenigstens einen Wicklungsstern bzw. Sternarmelement erforderlich sind. Dies begünstigt die Erzielung niedriger Gesamtkosten, aber auch die Robustheit und Dauerzuverlässigkeit der Drosselspule. Außerdem ist dadurch eine Mehrfachfunktionalität der Bandelemente geschaffen. Insbesondere kann dadurch eine geringe Bauteilvielfalt, ein robuster Aufbau und eine langfristig zuverlässige Funktion der Ladungsableitungsschicht erzielt werden.

Darüber hinaus kann vorgesehen sein, dass der erste und zweite elektrisch leitfähige Wicklungsstern bzw. erste und zweite Sternarmelemente an den axialen Stirnenden der Luftdrosselspule durch das zumindest eine zweite Bandelement in Axialrichtung zusammengespannt sind, insbesondere zumindest während der Produktionsphase der Drosselspule bzw. der zumindest einen holzylindrischen Wicklungslage axial zusammengehalten sind bzw. unter Zwischenschaltung der zumindest einen hohlzylindrischen Wicklungslage in der gewünschten axialen Distanz zueinander gesichert sind. Dadurch kann die zumindest eine hohlzylindrische Wicklungslage mittels dem zumindest einen zweiten Bandelement in axialer Richtung zumindest anteilig oder auch primär zusammenhalten werden. Die zweiten Bandelemente weisen dabei neben ihrer Funktion als elektrische Ableitungspfade auch die Funktion von mechanischen Zugelementen auf. Vor allem bei kleineren Dimensionen von Luftdrosselspulen können dadurch sogenannte Spalt- bzw. Verbindungsleisten zwischen dem ersten und zweiten Wicklungsstern bzw. zwischen axial zueinander distanzierten Sternarmelementen völlig entfallen, wodurch die Materialkosten und auch die Herstellungsaufwände für solche Drosselspulen deutlich gesenkt werden können.

Vorteilhaft ist auch eine Ausprägung, gemäß welcher vorgesehen sein kann, dass das wenigstens eine zweite, axial verlaufende Bandelement in radialer Richtung näher zu der zumindest einen Wicklungslage angeordnet ist, als das zumindest eine wendelförmig verlaufende, erste Bandelement. Dementsprechend kann vorgesehen sein, das das wendelförmig verlaufende, erste Bandelement unmittelbar kontaktierend auf das axial verlaufende, zweite Bandelement gewickelt ist. In vorteilhafter Art und Weise wird dadurch das zweite Bandelement mittels dem ersten Bandelement in radialer Richtung gegen die äußere Mantelfläche bzw. gegen die Wicklungsisolation der zumindest einen hohlzylindrischen Wicklungslage gedrängt bzw. gedrückt. Ein allmähliches Ablösen bzw. Abheben des wenigstens zweiten Bandelementes von der Mantelfläche bzw. von der Wicklungsisolation kann dadurch zuverlässig hintan gehalten bzw. ausgeschlossen werden. Auch kann dadurch die axiale Spann- bzw. Zugkraft des zumindest einen zweiten Bandelementes in einfacher Art und Weise erhöht bzw. reguliert werden.

Gemäß einer vorteilhaften Ausgestaltung kann vorgesehen sein, dass das zumindest eine erste und das zumindest eine zweite Bandelement durch identische Bandmaterialen gebildet sind. Diese Gleichheit kann dabei durch den Werkstoff und/oder die Geometrie der Bandmaterialien definiert sein. Dadurch ist ein einfacher, möglichst kostengünstiger Aufbau erzielbar, bei welchem möglichst wenige, unterschiedliche Komponenten bzw. Elemente zum Einsatz kommen. Ein solches Gleichteilekonzept vereinfacht auch den entsprechenden Herstellungsablauf solcher Drosselspulen.

Ferner kann es zweckmäßig sein, wenn das elektrisch halb- bzw. teilleitfähige Material der Ladungsableitungsschicht bzw. des ersten und/oder zweiten Bandelementes einen Oberflächenwiderstand im Bereich von 10⁷ bis 10¹² Ohm/Quadrat, insbesondere im Bereich von 10⁸ bis 10¹⁰ Ohm/Quadrat aufweist. Dadurch ist ein optimierter Widerstandsbereich gegeben. Insbesondere können sich Nachteile einstellen, wenn man sich außerhalb dieses elektrischen Widerstandsbereichs befindet. Bei einem zu hohem Widerstand der Ladungsableitungsschicht können die Ladungsträger nicht mehr schnell genug abgeleitet werden und die gewünschte Funktion ist nicht mehr gegeben. Ein zu geringer Widerstand kann zu erhöhten Kriechströmen und einer damit verbundenen Schädigung der Drosselspule führen.

Darüber hinaus kann vorgesehen sein, dass zumindest ein Sternarm der Wicklungssterne oder ein Haltefortsatz an zumindest einem der Wicklungssterne von dem wenigstens einen zweiten Bandelement zumindest partiell umschlungen ist. Analoges gilt dann, wenn anstelle solcher Wicklungssterne an jedem der axialen Stirnenden der Luftdrosselspule baulich jeweils eigenständige, radial vergleichsweise kürzere, erste bzw. zweite Sternarmelemente ausgebildet sind. Dadurch ist eine hochfeste, abreißsichere und rasch herstellbare Verbindung zwischen dem wenigstens einen zweiten Bandelement und wenigstens einem der Wicklungssterne bzw. zwischen wenigstens zwei axial voneinander distanzierten Sternarmelementen erzielbar. Eine derartige elektrische Verbindung ist außerdem mechanisch robust. Insbesondere können so filigrane Überleitungsdrähte bzw. Verbindungsbrücken erübrigt werden.

Des Weiteren kann vorgesehen sein, dass das zumindest eine erste Bandelement zumindest innerhalb von Teilabschnitten der axialen Höhe der wenigstens einen Wicklungslage überlappend gewickelt ist. Dadurch ist eine praktikable Ausbildung einer vollflächigen bzw. lückenlosen Ladungsableitungsschicht geschaffen. Dies ermöglicht die Schaffung einer weitestgehend homogenen Ladungsableitungsschicht und bewirkt eine gleichmäßige Ableitung von elektrostatischen Ladungen. Die entsprechende Anbringung ist dabei sowohl bei Verwendung von relativ schmalen, als auch bei Verwendung von relativ breiten Bandelementen in einfacher Art und Weise möglich.

Gemäß einer alternativen oder kombinatorischen Ausprägung für den Aufbau der Ladungsableitungsschicht ist es möglich, dass das zumindest eine erste Bandelement zumindest innerhalb von Teilabschnitten der axialen Höhe der wenigstens einen Wicklungslage in Axialrichtung distanziert gewickelt ist, insbesondere schraubenlinienförmig gewickelt ist. Dadurch kann eine Ersparnis an Bandmaterial erreicht werden und kann trotzdem je nach den vorherrschenden Parametern, wie zum Beispiel Spannungsbereich, Partikelbelastung oder Leitfähigkeit des Bandmaterials, eine ausreichende Ableitung von elektrischen Ladungen gewährleistet werden.

Entsprechend einer vorteilhaften Ausführung kann vorgesehen sein, dass das zumindest eine erste und/oder zweite Bandelement ein Gewebe oder Gewirk aus Textil-, Glas- und/oder Kunststofffasern umfasst, welches Gewebe oder Gewirk mit Kunstharz und darin dispergierten, leitfähigen Partikeln versehen ist. Dadurch ist die vorbestimmte bzw. gewünschte Teil-Leitfähigkeit des Bandmaterials praktikabel und zuverlässig wähl- bzw. einstellbar. Zudem kann dadurch eine hohe Robustheit bzw. eine problemlos ausreichende Zugfestigkeit des zumindest einen Bandelements erzielt werden. Auch die elastische Dehnbarkeit des zumindest einen Bandelements kann dadurch innerhalb definierter Grenzen in einfacher Art und Weise voreingestellt bzw. angepasst werden.

Zudem kann es vorteilhaft sein, wenn das zumindest eine erste und/oder zweite Bandelement eine Dicke zwischen 0,1 mm bis 1,0 mm, vorzugsweise zwischen 0,2 mm bis 0,3 mm aufweist. Dadurch ist das wenigstens eine Bandelement leicht zu verarbeiten und zudem kann dadurch eine relativ geringe Schichtdicke der Ladungsableitungsschicht gewährleistet werden. Außerdem kann dadurch eine gute Anformung bzw. Anpassung des wenigstens einen Bandelements an die Mantelfläche bzw. an die Oberflächenstrukturen von der die Ladungsableitungsschicht tragenden, hohlzylindrischen Wicklungslage erzielt werden. Insbesondere kann dadurch auch eine möglichst spalt- bzw. hohlraumfreie Anbringung der Ladungsableitungsschicht an der äußeren Mantelfläche der zumindest einen hohlzylindrischen Wicklungslage begünstigt werden.

Die Aufgabe der Erfindung wird auch durch das anspruchsgemäße Verfahren gelöst. Dieses Verfahren zur Herstellung einer HVDC-Luftdrosselspule umfasst folgende Verfahrensschritte:
- Bereitstellen zumindest einer hohlzylindrischen Wicklungslage deren elektrischer Leiterdraht mitsamt seiner mantelseitigen Isolationsschicht wendelförmig um eine Spulenachse gewickelt ist,
- Beschichten der zumindest einen hohlzylindrischen Wicklungslage an ihrer äußeren Mantelfläche, welche Mantelfläche durch eine die Isolationsschicht des Leiterdrahtes umfassende Wicklungsisolation mit hoher elektrischer Isolationsfestigkeit definiert ist, mit einer Ladungsableitungsschicht, wobei die Ladungsableitungsschicht durch in Bezug auf die Spulenachse wendelförmiges Umwickeln der zumindest einen hohlzylindrischen Wicklungslage mit zumindest einem ersten Bandelement gebildet oder mitdefiniert wird, wobei dieses zumindest eine erste Bandelement mit einer vorbestimmten elektrischen Leitfähigkeit ausgewählt wird, welche vorbestimmte elektrische Leitfähigkeit geringer ist, insbesondere um einen Faktor 10¹⁵ bis 10²⁰ geringer ist, als eine elektrische Leitfähigkeit des elektrischen Leiterdrahtes, welche vorbestimmte elektrische Leitfähigkeit des zumindest einen ersten Bandelements jedoch höher ist, insbesondere um einen Faktor 10² bis 10⁷ höher ist, als eine elektrische Leitfähigkeit der mantelseitigen Isolationsschicht des Leiterdrahtes oder der die Isolationsschicht des Leiterdrahtes umfassenden, mantelseitigen Wicklungsisolation der hohlzylindrischen Wicklungslage.

Insbesondere erfolgt eine Anbringung einer Ladungsableitungsschicht an der äußeren Mantelfläche der zumindest einen hohlzylindrischen Wicklungslage durch ein in Bezug auf die Spulenachse wendelförmiges Umwickeln der zumindest einen hohlzylindrischen Wicklungslage mit zumindest einem ersten Bandelement. Dabei wird wenigstens die äußere Mantelfläche der radial äußersten, hohlzylindrischen Wicklungslage mit der wendelförmig aufgebrachten Ladungsableitungsschicht versehen.

Durch die erfindungsgemäßen Maßnahmen ist eine kostengünstige Herstellbarkeit für HVDC-Drosselspulen mit baulichen Maßnahmen zur Unterdrückung von feldstärkebedingten Partikelablagerungen erzielbar. Insbesondere wird dadurch eine zuverlässige, unter typischen Betriebsbedingungen gesicherte Ableitung von elektrischen Oberflächenladungen zu den Anschlüssen bzw. Stirnenden der HVDC-Luftdrosselspule, insbesondere zu wenigstens einem der elektrischen Anschlüsse der HVDC-Luftdrosselspule, ermöglicht. Zugleich ist der erfindungsgemäße Produktionsablauf relativ prozessstabil umsetzbar, sodass durch diesen Produktionsablauf plangemäße, qualitativ hochwertige HVDC-Luftdrosselspulen erzeugt werden können. Ein besonderer Vorteil des erfindungsgemäßen Verfahrens besteht auch darin, dass die jeweilige elektrische Wirkung der Ladungsableitungsschicht in einfacher Art und Weise an die jeweiligen Erfordernisse bzw. Rahmenbedingungen angepasst werden kann. Darüber hinaus kann eine anspruchsgemäß hergestellte bzw. aufgebaute Ladungsableitungsschicht problemlos und ohne besondere Vorbereitungen oder Vorkehrungen an eine Vielzahl unterschiedlicher Geometrien bzw. Abmessungen von HVDC-Luftdrosselspulen angepasst werden. Hierfür ist lediglich die Windungsanzahl, die Überlappungsweite und/oder die Breite des Bandelementes an die strukturellen Gegebenheiten der HVDC-Luftdrosselspule anzupassen. Insbesondere kann mit einer bestimmten Type eines halb- bzw. teil-leitfähigen Bandelementes die Schaffung von Ladungsableitungsschichten für eine Mehrzahl von geometrisch oder baulich unterschiedlichen Drosselspulen abgedeckt werden.

Entsprechend einer zweckmäßigen, weiterführenden Maßnahme kann auch eine Anbringung von zumindest einem axial zur zumindest einen hohlzylindrischen Wicklungslage verlaufenden, zweiten Bandelement aus elektrisch leitfähigem Material an der äußeren Mantelfläche der zumindest einen hohlzylindrischen Wicklungslage vorgesehen sein. Vorzugsweise sind mehrere, insbesondere zumindest drei bis acht, über den Umfang der hohlzylindrischen Wicklungslage verteilt angeordnete, axial verlaufende, zweite Bandelemente vorgesehen. Vorzugsweise erstrecken sich die zweiten Bandelemente über die gesamte axiale Höhe bzw. Länge der betreffenden, hohlzylindrischen Wicklungslage Dadurch werden definierte, axiale Ableitungspfade für elektrische Oberflächenladungen geschaffen, welche Ableitungspfade rationell aufgebaut werden können und eine gesicherte Abführung von elektrostatischen Ladungen in Richtung zu wenigstens einem der axialen Stirnenden der Luftdrosselspule gewährleisten.

Zweckmäßig kann es dabei sein, wenn die Anbringung des zumindest einen zweiten Bandelementes zeitlich vor dem Umwickeln der zumindest einen hohlzylindrischen Wicklungslage mit dem zumindest einen ersten Bandelement erfolgt, wobei das zumindest eine erste Bandelement und das zumindest eine zweite Bandelement an mehreren Überkreuzungsstellen einander direkt überkreuzend angebracht und dadurch elektrisch miteinander kontaktiert werden. Dadurch wird das zumindest eine zweite, axial verlaufende Bandelement durch das zumindest eine erste, wendelförmig verlaufende Bandelement gegen die äußere Mantelfläche der hohlzylindrischen Wicklungslage bzw. gegen deren Wicklungsisolation gedrängt und wird damit ein stabiler Aufbau geschaffen bzw. eine prozesssichere, qualitativ hochwertige Herstellung erzielt.

Vorteilhaft ist eine Bereitstellung und Implementierung von dem zumindest einen ersten und/oder zweiten Bandelement mit einer Breite zwischen 1 cm und 40 cm, vorzugsweise zwischen 2 cm und 10 cm, und einer Dicke zwischen 0,1 mm und 1,0 mm, vorzugsweise zwischen 0,2 mm bis 0,3 mm. Dies gewährleistet eine gute bzw. möglichst unkomplizierte Verarbeitbarkeit des wenigstens einen Bandelementes und ist zugleich ein rationeller Aufbau der Ladungsableitungsschicht ermöglicht.

Ferner kann es zweckmäßig sein, wenn das zumindest eine erste und/oder zweite Bandelement in Form eines mit Kunstharz getränkten oder beschichteten Gewebes oder Gewirkes, welches Gewebe oder Gewirke als Trägermaterial für das Kunstharz fungiert, bereitgestellt wird. Das Kunstharz des Bandelementes soll dabei einen pastösen bis festen, bei Raumtemperatur nicht-fließenden, teilvernetzten Zustand aufweisen. Insbesondere soll das Kunstharz im Verarbeitungszustand des wenigstens einen Bandelementes nur teilweise ausgehärtet bzw. erhärtet sein. Dies ermöglicht eine rationelle, prozesssichere und qualitativ hochwertige Herstellung der Ladungsableitungsschicht.

Gemäß einer besonderen Ausprägung ist es möglich, dass an jedem der axialen Stirnenden der zumindest einen hohlzylindrischen Wicklungslage je ein Wicklungsstern angebracht ist, und dass das zumindest eine zweite, axial verlaufende Bandelement mit wenigstens einem der beiden Wicklungssteme, vorzugsweise mit beiden Wicklungsstemen, insbesondere mit wenigstens einem der radial zur Spulenachse verlaufenden Sternarme, elektrisch kontaktiert wird. Dadurch wird eine zuverlässige bzw. möglichst unmittelbare Ableitung von Oberflächenladungen an der Wicklungsisolation der zumindest einen hohlzylindrischen Wicklungslage zu den Wicklungsstemen bzw. zu den auf definiertem Spannungspotential liegenden Anschlüssen der Luftdrosselspule gewährleistet.

Entsprechend einer vorteilhaften Verfahrensmaßnahme kann auch vorgesehen sein, dass die zumindest eine hohlzylindrische Wicklungslage und/oder das zumindest eine erste und/oder zweite Bandelement nach dem Aufwickeln respektive Anbringen an der zumindest einen hohlzylindrischen Wicklungslage aufgeheizt bzw. erwärmt wird/werden, sodass das Kunstharz an oder in dem zumindest einen ersten und/oder zweiten Bandelement chemisch reagiert und dabei das zumindest ein erste und das zumindest eine zweite Bandelement untereinander und/oder mit der äußeren Mantelfläche respektive mit der Wicklungsisolation der Wicklungslage verklebt werden. Dies ermöglicht die Schaffung einer robusten Ladungsableitungssicht, bei welcher Ablösungstendenzen von der hohlzylindrischen Wicklungslage bzw. von deren Wicklungsisolation, welche typischerweise ebenso auf Kunstharz basiert bzw. Kunstharz enthält, nahezu ausgeschlossen werden können.

Entsprechend einer vorteilhaften Ausgestaltung kann vorgesehen sein, dass das zumindest eine erste Bandelement zumindest innerhalb von Teilabschnitten einer axialen Höhe der zumindest einen hohlzylindrischen Wicklungslage einander überlappend gewickelt wird. Dadurch wird eine vollflächige bzw. lückenlose Überdeckung der Wicklungsisolation mit der Ladungsableitungsschicht ermöglicht. Diese Verfahrensmaßnahme begünstigt auch die Ausbildung einer möglichst glatten bzw. möglichst stufenlosen Oberfläche der Luftdrosselspule, wodurch die Anhaftung von Schmutz bzw. von in der Umgebungsluft enthaltenen Staubpartikeln weiter minimiert werden kann. Dies vor allem dann, wenn die Überlappung zwischen den axial benachbarten, wendelförmig verlaufenden Bandabschnitten schuppenartig bzw. dachziegelartig ausgebildet ist, insbesondere wenn das zumindest eine erste Bandelement derart gewickelt ist, dass es in Bezug auf eine vertikal ausgerichtete Spulenachse ausgehend von einer unteren Ausgangsposition wendelförmig in Vertikalrichtung nach oben verläuft.

Alternativ oder in Kombination zu einer überlappenden Anbringung des wenigstens einen ersten Bandelementes kann vorgesehen sein, dass das zumindest eine erste Bandelement zumindest innerhalb von Teilabschnitten einer axialen Höhe der zumindest einen hohlzylindrischen Wicklungslage in Axialrichtung voneinander beabstandet gewickelt wird. Dadurch ist ein geringerer Materialbedarf erzielbar bzw. kann dadurch die erforderliche Länge an Bandmaterial reduziert werden. Ein geringerer Materialbedarf kann dabei den Kostenaufwand reduzieren, wodurch eine kostengünstige Fertigung bei weiterhin ausreichender Ableitung von Oberflächenladungen erzielbar ist.

Zudem kann eine Aufbringung eines im seinem Verarbeitungszustand fließfähigen, nachfolgend verfestigbaren bzw. aushärtenden Stabilisierungsharzes vorgesehen sein. Vorzugsweise wird ein solches Stabilisierungsharz ausschließlich auf eine innere Mantelfläche der zumindest einen hohlzylindrischen Wicklungslage aufgebracht, sodass die mantelseitige Isolationsschicht des elektrischen Leiterdrahtes ausschließlich ausgehend von der inneren Mantelfläche der zumindest einen hohlzylindrischen Wicklungslage mit dem Stabilisierungsharz für die zumindest eine hohlzylindrische Wicklungslage getränkt wird. Dadurch kann in zuverlässiger sowie einfacher Art und Weise sichergestellt werden, dass auf die Außenseite der ableitfähigen Hülle bzw. der Ladungsableitungsschicht kein elektrisch isolierendes Stabilisierungsharz gelangt oder nur eine minimale, vernachlässigbar kleine Menge an Stabilisierungsharz daran anhaftet. Auf diese Weise kann die plangemäße Funktionalität der Ladungsableitungsschicht auf der Außenseite bzw. äußeren Mantelfläche der zumindest einen hohlzylindrischen Wicklungslage technisch einfach und trotzdem zuverlässig gesichert werden.

Entsprechend einer praktikablen Verfahrensmaßnahme wird der Verfahrensschritt des gegenseitigen Verklebens bzw. Verbindens des zumindest einen ersten und/oder zweiten Bandelementes zeitlich vor dem Verfahrensschritt des Aufbringens von flüssigem Stabilisierungsharz auf die innere Mantelfläche der zumindest einen hohlzylindrischen Wicklungslage vorgenommen. Dadurch kann in zuverlässiger sowie einfacher Art und Weise sichergestellt werden, dass beim Auf- bzw. Einbringen des flüssigen Stabilisierungsharzes für die zumindest eine hohlzylindrische Wicklungslage der elektrische Kontakt zwischen dem wenigstens einen ersten und zweiten Bandelement und/oder der elektrische Kontakt zwischen den in Axialrichtung einander überlappenden Windungen des zumindest einen zweiten Bandelementes erhalten bleibt und somit eine hohe Wirksamkeit der Ladungsableitungsschicht gewährleistet werden kann.

Entsprechend einer vorteilhaften Maßnahme kann vorgesehen sein, dass das wendelförmige Aufwickeln des elektrischen Leiterdrahtes mittels einem drehbaren, insbesondere einem aktiv angetriebenen, spulenartigen Wickelköper zur Ausbildung der zumindest einen hohlzylindrischen Wicklungslage erfolgt. Zweckmäßig ist es dabei, wenn das zumindest eine erste Bandelement auf die zumindest eine hohlzylindrische Wicklungslage aufgewickelt wird, bevor diese hohlzylindrische Wicklungslage vom spulenartigen Wickelkörper abgenommen bzw. entfernt wird. Diese ermöglicht eine rationelle Herstellung und ist dadurch auch ein möglichst maßhaltiger und qualitativ hochwertiger Produktionsprozess erzielbar. Dies vor allem deshalb, weil dadurch separate, zeit- und qualitätskritische Rüst- bzw. Umrüstschritte in Zusammenhang mit der Anbringung der Ladungsableitungsschicht erübrigt werden können.

Zum besseren Verständnis der Erfindung wird diese anhand der nachfolgenden Figuren näher erläutert.

Es zeigen jeweils in stark vereinfachter, schematischer und beispielhafter Darstellung:
- Fig. 1: eine Ausführungsform einer Luftdrosselspule in perspektivischer Ansicht von schräg oben;
- Fig. 2: die Luftdrosselspule nach Fig. 1 in perspektivischer Ansicht von schräg unten;
- Fig. 3: die Luftdrosselspule nach Fig. 1 in Schnittdarstellung mit einer vertikal verlaufenden Schnittebene;
- Fig. 4: eine Schema einer Luftdrosselspule mit drei konzentrisch angeordneten, hohlzylindrischen Wicklungslagen und einer Ladungsableitungsschicht an der radial äußersten Wicklungslage;
- Fig. 5: einen Abschnitt einer Luftdrosselspule in Ansicht von schräg oben mit einer Ladungsableitungsschicht an der äußeren Mantelfläche der radial äußersten, hohlzylindrischen Wicklungslage;
- Fig. 6: eine schematische Detaildarstellung einer Luftdrosselspule mit einer Ladungsableitungsschicht an der radial äußersten Mantelfläche;
- Fig. 7: ein Halbfabrikat einer Luftdrosselspule während einer Herstellungsphase einer Ladungsableitungsschicht in Kombination mit einer beispielhaften Wickelvorrichtung;
- Fig. 8: ein weiteres Ausführungsbeispiel einer Luftdrosselspule mit einer Ladungsableitungsschicht an der äußeren Mantelfläche der Luftdrosselspule.

Einführend sei festgehalten, dass in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

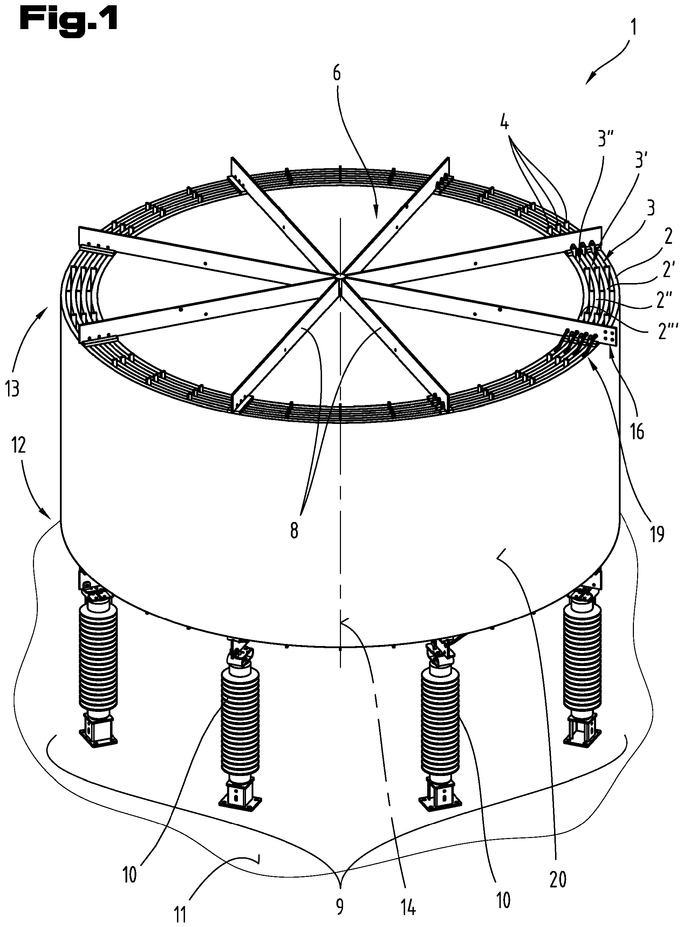

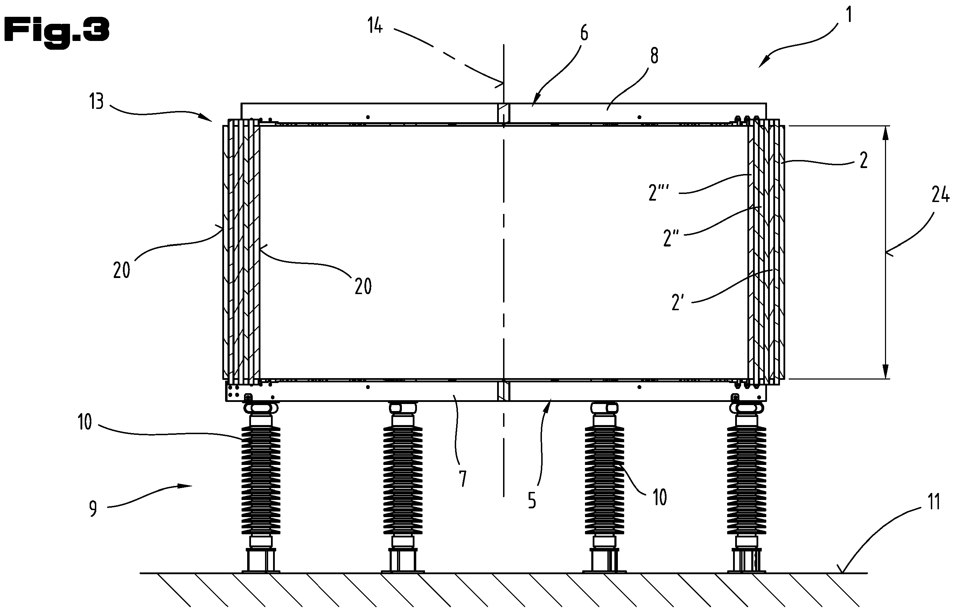

In den Fig. 1 bis 3 ist eine Ausführungsform einer HVDC-Luftdrosselspule 1 beispielhaft veranschaulicht. Diese elektrische Spule wird vereinfacht kurz Luftdrosselspule 1 bezeichnet. Sie besitzt keinen Eisenkern und gilt daher als sogenannte Luftdrosselspule. Sie ist für den elektrischen Mittel-, Hoch- und Höchstspannungsbereich vorgesehen. Typische Betriebs-Spannungswerte liegen über 10 kV und können bis in den Höchstspannungsbereich von 700 kV oder mehr reichen. Die entsprechenden Luftdrosselspulen 1 sind dabei für Hochvolt-Gleichspannungsabschnitte in elektrischen Energieversorgungs- bzw. Energieverteilungssystemen konzipiert, insbesondere für Hochspannungs-Gleichstromübertragungen (HGÜ) vorgesehen. Auch in Zusammenhang mit Industrieanlagen höheren elektrischen Energiebedarfs können solche HGÜ- bzw. HVDC-Luftdrosselspulen eingesetzt werden.

Die beispielhaft veranschaulichte Luftdrosselspule 1 weist vier konzentrisch zueinander angeordnete, im Wesentlichen hohlzylindrische Wicklungslagen 2, 2', 2", 2‴ auf. Typischerweise können zwei bis zehn solcher Wicklungslagen ausgebildet sein. In Einzelfällen können auch deutlich mehr als zehn hohlzylindrische, konzentrisch angeordnete Wicklungslagen vorgesehen sein. In der einfachsten Ausführungsform kann auch nur eine einzige hohlzylindrische Wicklungslage 2 vorgesehen sein. Im Betriebszustand der Luftdrosselspule 1 ist deren zentrale Achse bzw. Spulenachse 14 vertikal ausgerichtet.

Bei Ausbildung von zumindest zwei hohlzylindrischen, koaxial positionierten Wicklungslagen 2, 2', 2", 2‴ sind diese vorzugsweise unter Ausbildung von Luftspalte 3, 3', 3" zueinander angeordnet. Insbesondere weisen die einzelnen Wicklungslagen 2, 2', 2", 2‴ unterschiedliche Außendurchmesser auf, sodass im wesentlichen hohlzylindrische Kühlungs-Luftspalten 3, 3', 3" zwischen radial voneinander beabstandeten Begrenzungswänden der einzelnen, hohlzylindrischen Wicklungslagen 2, 2', 2", 2‴ ausgebildet werden.

Zur radialen, gegenseitigen Abstützung zwischen den konzentrisch zueinander positionierten, hohlzylindrischen Wicklungslagen 2, 2', 2", 2‴ können in den Kühlungs-Luftspalten 3, 3', 3" mehrere über den Kreisumfang verteilt angeordnete Spaltleisten 4 vorgesehen sein. Es ist aber auch eine Ausführungsform möglich, welche gänzlich ohne derartiger Spaltleisten 4 das Auslangen findet, oder welche in zumindest einem Kühlungs-Luftspalt 4 keine radial stützenden Spaltleisten 4 aufweist.

Optional und beispielsgemäß sind an den axialen Stirnenden 12, 13 der hohlzylindrischen Wicklungslagen 2, 2', 2", 2‴ jeweils Wicklungssterne 5, 6 ausgebildet, insbesondere ein unterer Wicklungsstern 5 und ein oberer Wicklungsstern 6 vorgesehen. Diese Wicklungssterne 5, 6 weisen jeweils im Wesentlichen strahlenförmig verlaufende, von einem zentralen Punkt ausgehende Sternarme 7, 8 auf. Es sind aber auch Ausführungsformen denkbar, bei welchem nur ein stirnseitiger Wicklungsstern 5 oder 6 vorgesehen ist, oder bei welcher kein stirnseitiger Wicklungsstern vorgesehen ist. Alternativ ist es anstelle von weitreichend ins Zentrum der hohlzylindrischen Wicklungslagen 2, 2', 2", 2‴ verlaufender Sternarme 7, 8 auch möglich, lediglich kurze Sternarmelemente vorzusehen, welche sich in radialer Richtung im Wesentlichen nur über die Dicke des durch die hohlzylindrischen Wicklungslagen 2, 2', 2", 2‴ definierten Wicklungspakets erstrecken, sich also in radialer Richtung im Wesentlichen nur über die jeweils vorgesehenen Wicklungslagen 2, 2', 2", 2‴erstrecken.

Entsprechend der dargestellten Ausführungsform ist eine Stützkonstruktion 9 umfassend mehrere Isolatoren 10 vorgesehen, über welche die Luftdrosselspule 1 auf einer im Wesentlichen horizontalen Abstützebene 11 lastabtragend gegenüber einem Bodenabschnitt abgestützt ist. Eine solche Stützkonstruktion 9 umfasst typischerweise mehrere punkt- bzw. säulenartige Abstützungen, sodass mehrere Abstützpunkte gegenüber der Abstützebene 11 ausgebildet sind. Die Stützkonstruktion 9 lagert vorzugsweise die Sternarme 7 des unteren Wicklungssterns 5 bzw. die relativ kurzen bzw. stummelartigen, radial ausgerichteten Sternarmelemente.

Der erste bzw. untere elektrisch leitfähige Wicklungsstern 5 ist dabei an einem ersten bzw. unteren axialen Stirnende 12 der zumindest einen hohlzylindrischen Wicklungslage 2 - 2‴ angeordnet. Der beispielsgemäß zweite bzw. obere elektrisch leitfähige Wicklungsstern 6 ist dem zweiten bzw. oberen axialen Stirnende 13 der zumindest einen hohlzylindrischen Wicklungslage 2 - 2‴ nächstliegend zugeordnet.

Eine Spulenachse 14 der Luftdrosselspule 1 ist durch die zentrale Achse der zumindest einen hohlzylindrischen Wicklungslage 2 - 2‴ definiert und erstreckt sich in Bezug auf den Einsatzzustand der Luftdrosselspule 1 in vertikaler Richtung. Demnach erstreckt sich die Spulenachse 14 der Luftdrosselspule 1 zwischen dessen ersten und zweiten axialen Stirnende 12, 13

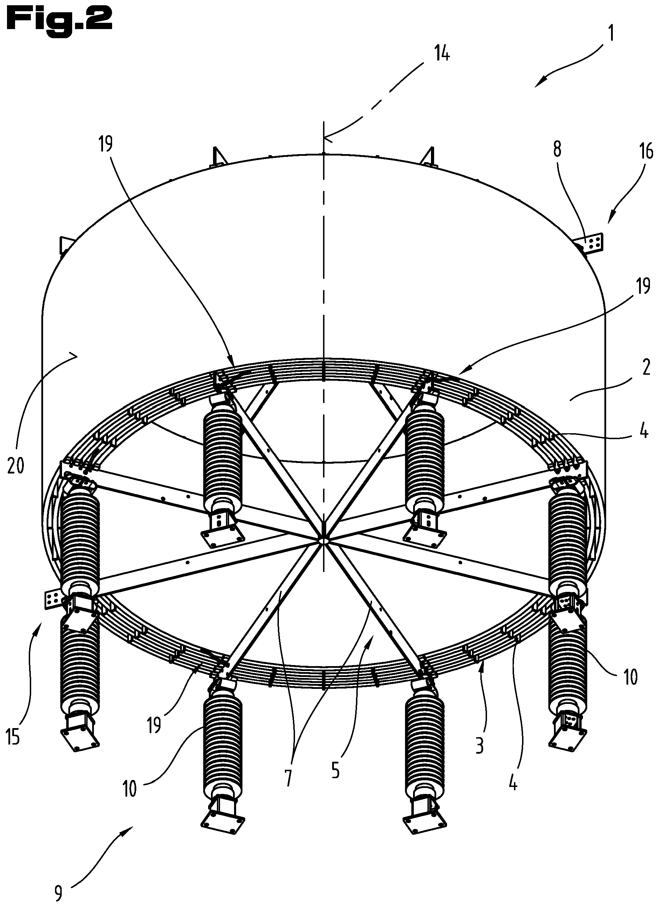

Zur elektrischen An- bzw. Einbindung der Luftdrosselspule 1 weist diese zumindest zwei elektrische Anschlüsse 15, 16 auf. Typischerweise sind diese den jeweiligen Wicklungssternen 5, 6 bzw. einzelnen Sternarmen 7, 8 zugeordnet bzw. daran ausgebildet. Wie am besten aus Fig. 2 ersichtlich ist, kann der erste elektrische Anschluss 15 an einem Sternarm 7 des unteren Wicklungsstems 5 ausgebildet sein und der zweite elektrische Anschluss 16 der Luftdrosselspule 1 an einem Sternarm 8 des oberen Wicklungsstems 6 ausgebildet sein. Zwischen den Anschlüssen 15, 16 ist die definierte elektrische Induktivität der Luftdrosselspule 1 gegeben. Weiters können verschiedene Spulenanzapfungen an sonstigen Stellen der Luftdrosselspule 1 ausgebildet sein, insbesondere an von den Sternarmen 7, 8 elektrisch isolierten Stellen bzw. Positionen der Luftdrosselspule 1.

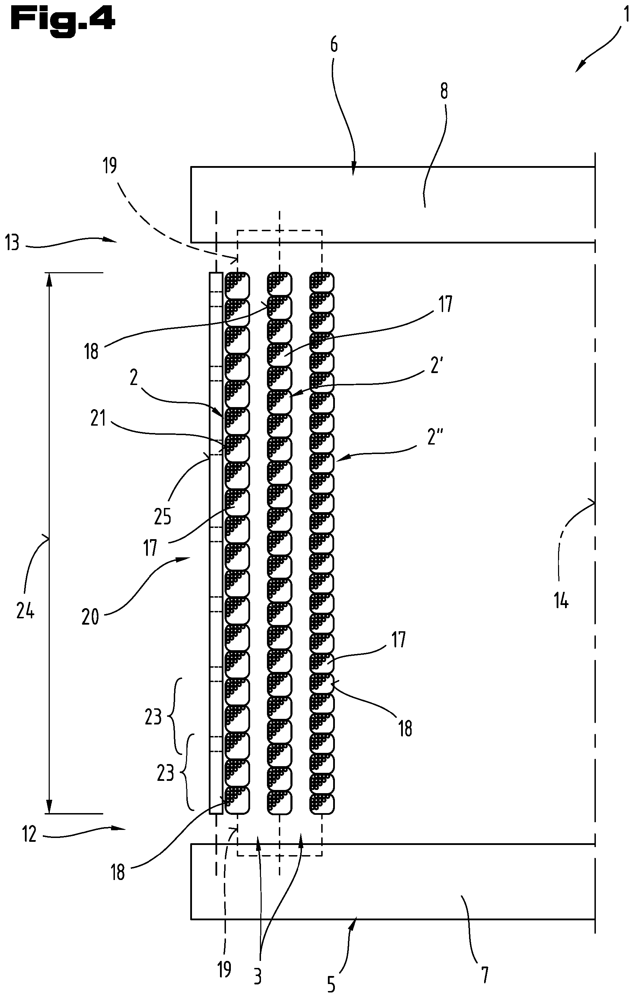

Fig. 4 zeigt stark schematisiert den elektrischen Grundaufbau einer Luftdrosselspule 1. Daraus ist unter anderem ersichtlich, dass die einzelnen, konzentrisch zur Spulenachse 14 angeordneten Wicklungslagen 2, 2', 2" elektrisch parallel geschaltet sind, insbesondere via den oberen und unteren Wicklungsstern 5, 6 elektrisch parallel miteinander verschaltet werden. Die zwischen den einzelnen Wicklungslagen 2, 2', 2" jeweils ausgebildeten Luftspalte 3 sind in ihrer radialen Breite jeweils von den Durchmessern der einzelnen Wicklungslagen 2, 2', 2" abhängig.

Wie an sich bekannt, ist jede der hohlzylindrischen Wicklungslagen 2, 2', 2" durch wendelförmig um die Spulenachse 14 gewickelten Leiterdraht 17 definiert. Typischerweise weist der Leiterdraht 17 einen im Wesentlichen rechteckigen oder ovalen Querschnitt auf, geformt aus einem Massivleiter oder aus einem Leiterbündel. Letzteres kann seilartig oder als Litzenkabel ausgebildet sein.

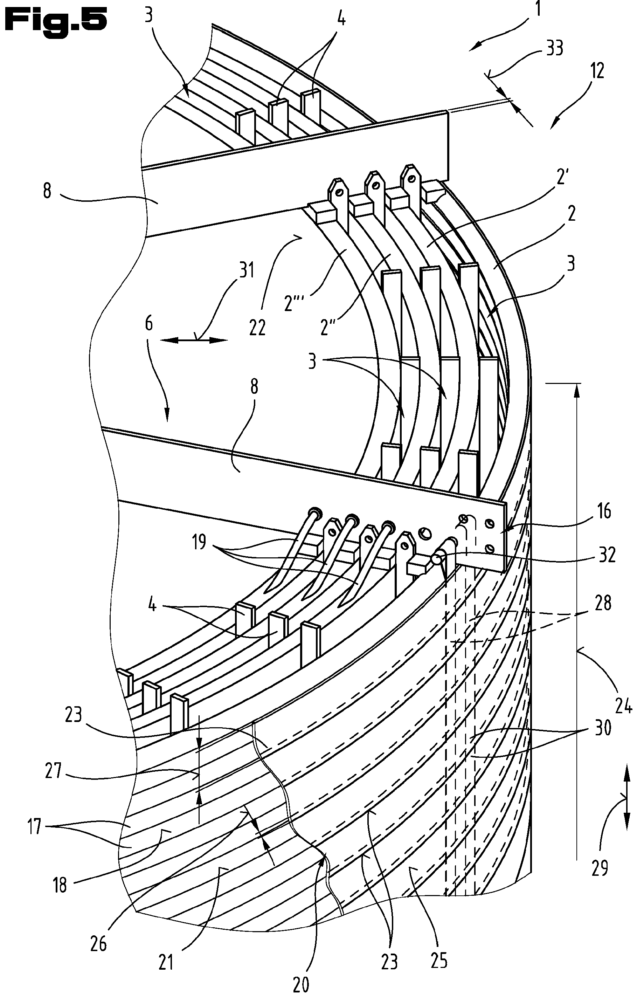

Die Mantelflächen des wendelförmig gewickelten Leiterdrahtes 17 weisen eine elektrische Isolationsschicht 18 auf, welche als Kunststoffummantelung ausgeführt sein kann. Typischerweise ist diese mantelseitige Isolationsschicht 18 des Leiterdrahtes 17 durch bandagenartig um die Mantelfläche des Leiterdrahtes 17 gewickeltes Isolationsmaterial gebildet. Dieses Isolationsmaterial kann beispielsweise durch ein kunstharzgetränktes, härtbares Gewebematerial definiert sein. Die Isolationsschicht 18 ist derart ausgeführt, dass die einzelnen Windungen bzw. Leitungsabschnitte von axial übereinander liegenden Leiterdrähten 17 der hohlzylindrischen Wicklungslagen 2, 2', 2" elektrisch voneinander isoliert sind. Nähere Details und Einzelheiten zum Grundaufbau solcher Luftdrosselspulen 1 sind beispielsweise der AT501074A1, welche auf die Anmelderin zurückgeht, entnehmbar. Der Leiterdraht 17 mit seiner mantelseitigen, elektrischen Isolationsschicht 18 ist dabei derart wendelförmig um die Spulenachse 14 gewickelt, dass die einzelnen Windungen der hohlzylindrischen Wicklungslagen 2, 2', 2" vorzugsweise lückenlos bzw. spaltfrei übereinander angeordnet sind, das heißt ohne axialen Abstand direkt aufeinander liegend positioniert sind, wie dies in Fig. 4 schematisch veranschaulicht ist und zudem in Fig. 5 illustrativ dargestellt wurde.

Fig. 5 zeigt das obere Stirnende einer Luftdrosselspule 1 in vergrößerter, auszugsweiser Darstellung. Hierbei sind vier elektrisch parallel geschaltete Wicklungslagen 2, 2', 2", 2‴ vorgesehen und elektrisch parallel geschaltet. Luftspalte 3 zwischen den einzelnen Wicklungslagen dienen der Kühlung der Luftdrosselspule 1 während ihres Betriebszustandes. Beispielsgemäß angeordnete Spaltleisten 4 halten die einzelnen Wicklungslagen 2, 2', 2", 2‴ in ihrem vorgesehenen radialen Abstand zueinander. Dementsprechend sind die Spaltleisten 4 zumindest in einzelnen der hohlzylindrischen Luftspalten 3 angeordnet. Beispielsgemäß sind Spulenenden 19 der Wicklungslagen 2', 2", 2‴ mit dem Sternarm 8 des oberen Wicklungsstems 6 elektrisch leitend verbunden. Dieser Sternarm 8 definiert auch den oberen elektrischen Anschluss 16 der Luftdrosselspule 1.

Zur Reduzierung oder Vermeidung elektrostatischer Aufladungen in bzw. an wenigstens einer der Oberflächen der hohlzylindrischen Wicklungslagen 2-2‴ ist wenigstens eine Ladungsableitungsschicht 20 an wenigstens einer der Mantelflächen 21 der hohlzylindrischen Wicklungslagen 2-2‴ ausgebildet. Wie in Fig. 5 veranschaulicht, ist vorzugsweise lediglich an der äußeren Mantelfläche 21 der radial äußersten Wicklungslage 2 eine Ladungsableitungsschicht 20 ausgebildet. Diese Ladungsableitungsschicht 20 bedeckt vorzugsweise die gesamte äußere zylindrische Mantelfläche 21 der hohlzylindrischen Wicklungslage 2. Zudem ist es möglich, auch die zur Spulenachse 14 nächstliegende, insbesondere die radial innerste Wicklungslage 2‴ an ihrer inneren Mantelfläche 22 mit einer Ladungsableitungsschicht 20 zu versehen. Typischerweise ist zumindest an der äußeren Mantelfläche 21 der radial äußersten, hohlzylindrischen Wicklungslage 2 eine Ladungsableitungsschicht 20 mit einer vorbestimmten, elektrischen Leitfähigkeit ausgebildet, um so übermäßige elektrostatische Aufladungen der äußeren Mantelfläche 21 der hohlzylindrischen Wicklungslage 2 bzw. der Wicklungsisolation der hohlzylindrischen Wicklungslage 2 hintanzuhalten und in weiterer Folge die Ausbildung von allmählichen, punktförmigen Verunreinigungen an der Oberfläche der Luftdrosselspule 1 hintanzuhalten.

Die zumindest eine Ladungsableitungsschicht 20 der Luftdrosselspule 1 ist dabei mit wenigstens einem der elektrischen Anschlüsse 15, 16 elektrisch leitend verbunden. Vorzugsweise ist die zumindest eine Ladungsableitungsschicht 20 an ihren beiden axialen Endabschnitten mit jeweils einem der beiden elektrischen Anschlüsse 15, 16 der Luftdrosselspule 1 elektrisch leitfähig verbunden. Dementsprechend bildet die Ladungsableitungsschicht 20, welche unmittelbar an der elektrisch isolierenden Mantelfläche 21 der radial äußersten hohlzylindrischen Wicklungslage 2 angeordnet ist, eine elektrische Parallelschaltung zu den hohlzylindrischen Wicklungslagen 2-2‴ aus. Insbesondere sind die jeweiligen axialen Endabschnitte der Ladungsableitungsschicht 20 durch die elektrische Verbindung zu den elektrischen Anschlüssen 15, 16 der Luftdrosselspule 1 definiert gepolt bzw. auf definiertes elektrisches Potential gelegt. Dementsprechend werden Oberflächenladungen, welche sich in bzw. an der Wicklungsisolation allmählich ansammeln, in Richtung zu wenigstens einem der beiden elektrischen Anschlüsse 15, 16 der Luftdrosselspule 1, welche Anschlüsse 15, 16 während dem Betrieb der Luftdrosselspule 1 auf einem definierten elektrischen Spannungspotential liegen, abgeleitet. Folglich bildet die Ladungsableitungsschicht 20 mit ihrer vorbestimmten elektrischen Leitfähigkeit einen elektrischen Parallelwiderstand zu der zumindest einen hohlzylindrischen Wicklungslage 2-2‴ aus.

Erfindungsgemäß umfasst die Ladungsableitungsschicht 20 zumindest ein erstes Bandelement 23 aus elektrisch leitfähigem bzw. teilleitfähigem Material. Dieses wenigstens eine erste Bandelement 23 verläuft wendelförmig bzw. schraubenlinienförmig um die Spulenachse 14 und liegt dabei an der elektrisch isolierenden, äußeren Mantelfläche 21 der zumindest einen hohlzylindrischen Wicklungslage 2-2‴ an. Vorzugsweise ist das zumindest eine erste Bandelement 23 zumindest auf die radial äußere Mantelfläche 21 der radial äußersten, hohlzylindrischen Wicklungslage 2 aufgewickelt. Diese Umwickelung der äußeren Wicklungslage 2 erfolgt vorzugsweise mit gleichbleibender Steigung wendelförmig in Bezug auf die Spulenachse 14. Dementsprechend kann so die gesamte axiale Höhe 24 oder auch nur ein Teilabschnitt der axialen Höhe 24 der zumindest einen hohlzylindrischen Wicklungslage 2-2‴ mit der Ladungsableitungsschicht 20 versehen werden.

Das zumindest eine erste Bandelement 23 kann dabei in gleichsinniger Wicklungsrichtung im Vergleich zum Leiterdraht 17 der hohlzylindrischen Wicklungslage 2 auf deren Mantelfläche 21 aufgewickelt sein. Insbesondere können in Bezug auf die Spulenachse 14 der Leiterdraht 17 und das zumindest eine erste Bandelement 23 jeweils rechtssinnig oder jeweils linkssinnig aufgewickelt sein.

Entsprechend einer vorteilhaften Ausführungsform sind der Leiterdraht 17 und das zumindest eine erste Bandelement 23 zueinander gegensinnig um die Spulenachse 14 verlaufend. Beispielsweise kann der Leiterdraht 17 rechtssinnig gewickelt sein und das zumindest eine erste Bandelement 23 linkssinnig bzw. linksdrehend gewickelt sein, sodass diese Wicklungsrichtungen gegenläufig sind. Dadurch kann in vorteilhafter Art und Weise eine relativ ebenflächige bzw. möglichst plan verlaufende äußere Ableitungsoberfläche 25 der Ladungsableitungsschicht 20 geschaffen werden. Aufgrund des ebenen Verlaufs dieser Ableitungsoberfläche 25 kann die Anhaftung von Schmutz oder von Flüssigkeitspartikeln weiter hintangehalten werden. Ein gegensinniger Wicklungsverlauf kann vor allem dann zweckmäßig sein, wenn das zumindest eine erste Bandelement 23 relativ schmal ausgeführt ist, insbesondere eine axiale Höhe bzw. eine Bandbreite 27 aufweist, welche in einem Bereich von etwa 50 % bis 200 % einer axialen Höhe bzw. axialen Dicke des Leiterdrahtes 17 liegt. Vor allem dann kann ein gegensinniger Wicklungssinn eine relativ ebenflächige bzw. glatte Ableitungsoberfläche 25 bewirken.

Das zumindest eine erste Bandelement 23 ist vorzugsweise zumindest innerhalb von Teilabschnitten der axialen Höhe 24 der wenigstens einen Wicklungslage 2-2‴ gegenseitig überlappend gewickelt. Dementsprechend liegen in Axialrichtung - Pfeil 29 - benachbarte Windungsabschnitte des zumindest einen ersten Bandelementes 23 in teilweiser Überdeckung zueinander. Eine Überlappungsweite 26 in dem zumindest einen ersten Bandelement 23 kann dabei geringfügig sein, insbesondere zwischen 1 % bis 10 % betragen, oder bis zu 50 % einer Bandbreite 27 des zumindest einen ersten Bandelementes 23 betragen. Das zumindest eine erste Bandelement 23 ist dabei mit der Mantelfläche 21 bzw. mit der Wicklungsisolation von der die Ladungsableitungsschicht 20 tragenden, hohlzylindrischen Wicklungslage 2-2‴ fest verbunden, insbesondere verklebt. Vorzugsweise ist eine harzbasierte Klebeverbindung zwischen dem zumindest einen ersten Bandelement 23 für die Ladungsableitungsschicht 20 und der Mantelfläche 21 der Wicklungslage 2-2‴ vorgesehen. Vorzugsweise ist zwischen der mantelseitigen Isolationsschicht 18 des Leiterdrahtes 17 und dem zumindest einen ersten Bandelement 23 für die Ladungsableitungsschicht 20 eine harzgekoppelte bzw. harzgetränkte, stoffschlüssige Verbindung aufgebaut. Hierfür wird sind das zumindest eine erste Bandelement 23 und die Isolationsschicht 18 der Leiterdrähte 17 jeweils harzgetränkt bzw. mit Kunstharz 35 beschichtet. Das entsprechende Kunstharz 35 gewährleistet in seinem ausgehärteten Zustand eine innige Verbindung zwischen den Windungen des zumindest einen ersten Bandelements 23 und der Isolationsschicht 18, welche an den einzelnen Mantelflächen der Leiterdrähte 17 ausgebildet ist und letztendlich die eigentliche Mantelfläche 21 der hohlzylindrischen Wicklungslage 2-2‴ definiert. In Fig. 5 ist der Schichtaufbau der Wicklungslage 2 mit ihrer äußeren Mantelfläche 21 und der darauf aufgebrachten Ladungsableitungsschicht 20 schematisch veranschaulicht.

Bei der Ausgestaltung nach Fig. 5 beträgt die axiale Höhe eines Leiterdrahtes 17 nur einen Bruchteil, insbesondere weniger als 50 %, vorzugsweise weniger als 40 % der Bandbreite 27 des Bandelementes 23. Zweckmäßig ist es, wenn die Bandbreite 27 des zumindest einen ersten Bandelementes 23 zwischen 1 % und maximal 20 % der axialen Höhe 24 der Wicklungslage 2-2‴ beträgt. Vorzugsweise sind zumindest fünf vollumfänglich verlaufende Windungen des Bandelementes 23 vorgesehen. Diese zumindest fünf Windungen des zumindest einen ersten Bandelementes 23 ergeben dabei eine vorzugsweise vollflächige Bedeckung der Mantelfläche 21 und eine in sich geschlossene Ladungsableitungsschicht 20. Typischerweise sind zwischen fünf bis etwa 100 Windungen von dem zumindest einen ersten Bandelement 23 zweckmäßig, um die gesamte axiale Höhe 24 mit dem zumindest einen ersten Bandelement 23 zu überdecken.

Zweckmäßig kann es sein, wenn in Bezug auf eine Luftdrosselspule 1 mit vertikal verlaufender Spulenachse 14 die in Axialrichtung - Pfeil 29 - überlappenden Bandabschnitte des zumindest einen ersten Bandelementes 23 derart ausgeführt sind, dass ein axial höher positionierter Bandabschnitt partiell über dem axial niedriger positionierten Bandabschnitt liegt. Mit anderen Worten ist dabei das zumindest eine erste Bandelement 23 wendelförmig von unten nach oben auf die äußere Mantelfläche 21 der radial äußeren hohlzylindrischen Wicklungslage 2 gewickelt. Insbesondere ergibt dies eine dachziegelartige bzw. schuppenförmige, axiale Überlappung der Bandabschnitte des zumindest einen ersten Bandelementes 23. Dadurch wird ein Wassereintritt erschwert und die Möglichkeiten zur Schmutzablagerung werden reduziert.

In Bezug auf die Radialrichtung - Pfeil 31 - der Drosselspule 1 ist vorzugsweise nur eine einzige Lage aus dem zumindest einen ersten Bandelement 23 vorgesehen, um die Ladungsableitungssicht 20 aufzubauen. Alternativ ist es auch denkbar, mit dem zumindest einen ersten Bandelement 23 mehrere radial übereinander liegende Lagen vorzusehen, um die Ladungsableitungsschicht 20 auszubilden. Die einzelnen Lagen aus dem zumindest einen ersten Bandelement 23 können gleichsinnig gewickelt sein, oder vorzugsweise gegensinnig gewickelt sein, also einander überkreuzende Windungen aus dem zumindest einen ersten Bandelement 23 umfassen. Das zumindest eine erste Bandelement 23 kann durchgängig über die gesamte axiale Höhe 24 der hohlzylindrischen Wicklungslage 2-2‴ verlaufen, oder durch mehrere erste Bandelemente 23 gebildet sein, welche jeweils wendelförmig auf die Mantelfläche 21 der hohlzylindrischen Wicklungslage 2-2‴ gewickelt sind.

Das elektrisch leitfähige Material des zumindest einen ersten Bandelementes 23 bzw. der letztendlich geschaffenen Ladungsableitungsschicht 20 besitzt vorzugsweise einen Oberflächenwiderstand im Bereich von 10⁷ bis 10¹² Ohm/Quadrat, insbesondere im Bereich von 10⁸ bis 10¹⁰ Ohm/Quadrat. Damit ist ein guter Kompromiss zwischen einer funktionalen Leitfähigkeit und einem guten bzw. ausreichenden elektrischen Isolationswiderstand der Ladungsableitungsschicht 20 gegeben.

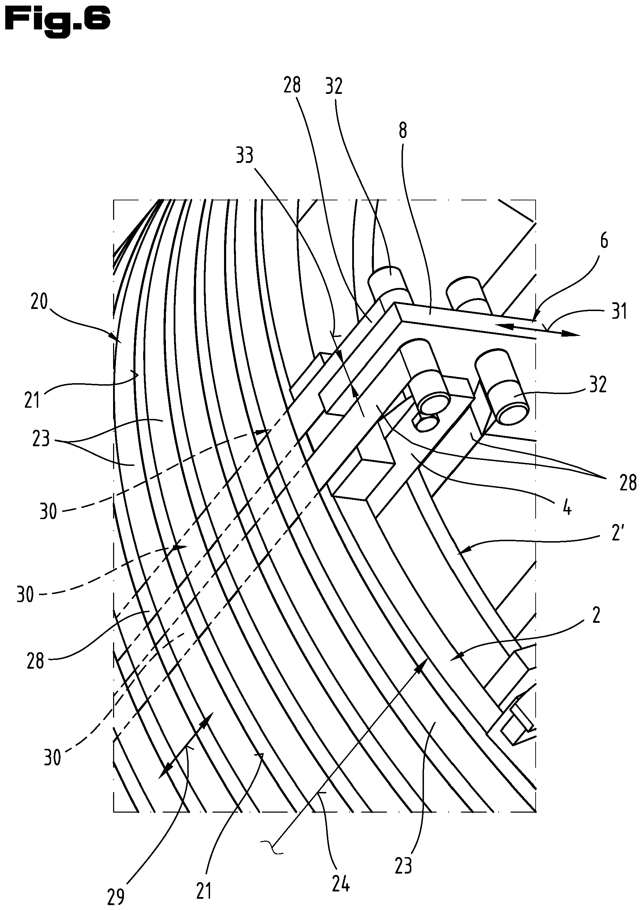

Wie am besten aus einer Zusammenschau der Fig. 5, 6 ersichtlich ist, kann die Ladungsableitungsschicht 20 zumindest ein zweites Bandelement 28 aus elektrisch leitfähigem Material umfassen. Dieses zumindest eine axial verlaufende, zweite Bandelement 28 bildet zusammen mit dem zumindest einen ersten, wendelförmig verlaufenden Bandelement 23 die Ladungsableitungsschicht 20 aus. Insbesondere ist das zumindest eine zweite Bandelement 28 dafür vorgesehen, eine gute bzw. langfristig stabile elektrische Kontaktierung zwischen dem zumindest einen ersten Bandelement 23 und dem zumindest einen Wicklungsstern 5, 6 bzw. dem zumindest einen elektrischen Anschluss 15, 16 der Luftdrosselspule 1 zu gewährleisten. Das zumindest eine zweite Bandelement 28 erstreckt sich in Axialrichtung - Pfeil 29 - der Luftdrosselspule 1 und liegt dabei vorzugsweise an der äußeren Mantelfläche 21 der zumindest einen hohlzylindrischen Wicklungslage 2-2‴ an. Wie am besten aus Fig. 5, aber auch aus Fig. 6 ersichtlich ist, ist dadurch gewährleistet, dass das zumindest eine erste Bandelement 23 und das zumindest eine zweite Bandelement 28 an mehreren Überkreuzungsstellen 30 einander querend verlaufen bzw. überkreuzend angeordnet sind. Vorzugsweise sind wenigstens an einzelnen dieser Überkreuzungsstellen 30 das zumindest eine erste elektrisch leitfähige Bandelement 23 und das zumindest eine zweite elektrisch leitfähige Bandelement 28 elektrisch leitfähig miteinander kontaktiert. Dies gewährleistet eine elektrisch gut funktionierende Ladungsableitungsschicht 20.

Das zumindest eine zweite elektrisch leitfähige Bandelement 28 ist mit wenigstens einem der Wicklungssterne 5 oder 6, vorzugsweise mit beiden elektrischen Wicklungssternen 5, 6 elektrisch leitfähig kontaktiert. Insbesondere ist vorgesehen, dass der erste elektrisch leitfähige Wicklungsstern 5, welcher am ersten axialen Stirnende 12 der zumindest einen Wicklungslage 2-2‴ angeordnet ist und der zweite elektrisch leitfähige Wicklungsstern 6, welcher an dem zweiten axialen Stirnende 13 dieser zumindest einen Wicklungslage 2-2‴ angeordnet ist, mittels dem zumindest einen zweiten Bandelement 28 elektrisch leitfähig verbunden wird. Insbesondere ist das wenigstens eine zweite, axial zur Luftdrosselspule 1 verlaufende Bandelement 28 ein elektrisch leitfähiges Verbindungselement zwischen dem ersten und dem zweiten Wicklungsstern 5, 6. Das zumindest eine axial verlaufende, zweite Bandelement 28 verbindet also den ersten und zweiten Wicklungsstern 5, 6 mit vorbestimmter, elektrischer Leitfähigkeit. Entsprechendes gilt auch dann, wenn anstelle von Wicklungsstemen 5, 6 bzw. Sternarmen 7, 8 in Radialrichtung - Pfeil 31 - relativ kurze Sternarmelemente vorgesehen sind.

Zweckmäßig ist es, wenn der erste und zweite elektrisch leitfähige Wicklungsstern 5, 6 durch das zumindest eine zweite Bandelement 28 in Axialrichtung - Pfeil 29 - mit vorbestimmter Zugspannung zusammengespannt sind. Diese Zugspannung kann dabei wenige Newton bis zu mehreren hundert Newton betragen. Insbesondere kann diese Zugspannung von der Zugfestigkeit bzw. vom Dehnungsverhalten des zumindest einen zweiten Bandelementes 28 abhängig gemacht werden. Zweckmäßig ist es, wenn das zumindest eine zweite Bandelement 28 eine hohe Zugfestigkeit aufweist, um so den ersten und zweiten Wicklungsstern 5, 6 gegen die Stirnenden der hohlzylindrischen Wicklungslagen 2-2‴ zu pressen. Entsprechendes gilt auch dann, wenn anstelle von Wicklungsstemen 5, 6 bzw. Sternarmen 7, 8 in Radialrichtung - Pfeil 31 - relativ kurze Sternarmelemente vorgesehen sind.

Dementsprechend kann ein axiales Auseinanderdriften der einzelnen Windungen der hohlzylindrischen Wicklungslagen 2-2‴ unter anderem durch das zumindest eine zweite Bandelement 28 hintangehalten werden. Die Vorspannkraft des zumindest einen zweiten Bandelementes 28 kann dabei auch nur ein Bruchteil der insgesamt benötigten Vorspannung betragen, welche ein Auseinanderweiten der einzelnen Windungen unterbindet. Insbesondere kann eine Harzbeschichtung bzw. eine Harztränkung der Isolationsschicht 18 der Leiterdrähte 17 einem ungewollten Auseinanderdriften der einzelnen Windungen entgegenwirken. Zudem können die Spaltleisten 4 eine diesbezügliche Funktion übernehmen, wenn diese - wie in Fig. 5 angedeutet - zumindest an einzelnen Stellen mit den beiden Wicklungssternen 5, 6 verbunden, insbesondere verschraubt, sind. Vorzugsweise sind mehrere über den Kreisumfang der Luftdrosselspule 1 verteilt angeordnete, zweite Bandelemente 28 vorgesehen. Die axialen Verläufe des zumindest einen zweiten Bandelementes 28 sind vorzugsweise an jenen Umfangspositionen, an welchen einzelne Sternarme 7, 8 der Wicklungssterne 5, 6 die hohlzylindrischen Wicklungslagen 2-2‴ überspannen bzw. radial überqueren. Das zumindest eine zweite Bandelement 28 kann entlang der radial äußeren Mantelfläche 21 und optional auch an der radial inneren Mantelfläche 22 der zumindest einen hohlzylindrischen Wicklungslage 2-2‴ verlaufen.

Anstelle der in den Fig. 1-3, 5 und 8 beispielhaft dargestellten Wicklungssterne 5, 6 mit bis zur Spulenachse 14 bzw. nahe zur Spulenachse 14 verlaufenden Sternarmen 7, 8 ist es auch möglich, die Luftdrosselspule 1 an einem der axialen Stirnenden 12, 13 oder an beiden axialen Stirnenden 12, 13 mit stummelartigen, radial verlaufenden Sternarmelementen auszuführen. Solche stummelartigen Sternarmelemente erstrecken sich in radialer Richtung im Wesentlichen nur über die radiale Dicke des Wicklungspaketes aus hohlzylindrischen Wicklungslagen 2-2 ` ` `.

Wie weiters den Fig. 5, 6 zu entnehmen ist, kann es zweckmäßig sein, wenn das wenigstens eine zweite, axial verlaufende Bandelement 28 in Radialrichtung - Pfeil 31 - näher zu der zumindest einen hohlzylindrischen Wicklungslage 2-2‴ angeordnet ist, als das zumindest eine wendelförmig verlaufende, erste Bandelement 23. Dementsprechend ist vorzugsweise vorgesehen, dass das zumindest eine zweite Bandelement 28 von dem wenigstens einen ersten Bandelement 23 umwickelt bzw. überwickelt ist und so gegen die Mantelfläche 21 der jeweiligen Wicklungslage 2-2‴ gedrängt bzw. gedrückt wird.

Das zumindest eine erste und das zumindest eine zweite Bandelement 23, 28 kann dabei durch technisch bzw. aufbaubezogen identische Bandmaterialien gebildet sein. Die jeweiligen Bandbreiten 27 können jedoch variieren. Zudem kann vorgesehen sein, dass das zumindest eine zweite Bandelement 28 eine höhere Dehnungsfestigkeit aufweist als das zumindest eine erste Bandelement 23.

Zumindest ein Sternarm 7 oder 8, vorzugsweise jeweils mehrere Sternarme 7, 8 der Wicklungssterne 5, 6 kann/können von dem zumindest einen zweiten Bandelement 28 zumindest partiell umschlungen sein, um eine zuverlässige Kontaktierung und eine optimierte Aufbringung von Zugkräften erzielen zu können. Alternativ oder in Kombination dazu ist es möglich, dass an zumindest einem Sternarm 7, 8 von zumindest einem der Wicklungssterne 5, 6 jeweils wenigstens ein Haltefortsatz 32 ausgebildet ist, welcher von dem wenigstens einen zweiten Bandelement 28 zumindest partiell umschlungen ist. Insbesondere können an den Sternarmen 7, 8 der Wicklungssterne 5, 6 Haltefortsätze 32 vorgesehen sein, welche eine zugfeste Verbindung bzw. Verankerung gegenüber dem zumindest einen zweiten Bandelement 28 ermöglichen. Diese Haltefortsätze 32 können dabei bolzenartig ausgeführt sein und die distalen Enden zumindest einzelner Sternarme 7, 8 via Bohrungen durchsetzen. Die Haltefortsätze 32 können entsprechend einer Weiterbildung auch als Spann- bzw. Wickelvorrichtung ausgeführt sein, um während der Herstellung der Luftdrosselspule 1 eine Zugkraft auf das zumindest eine zweite Bandelement 28 ausüben zu können.

Zweckmäßig ist es, wenn jeweils Paare von zweiten Bandelementen ausgeführt sind, welche Paare in Bezug auf die Kreisumfangsrichtung der hohlzylindrischen Wicklungslage 2-2‴ an unmittelbar gegenüberliegenden Flachseiten des jeweiligen Sternarms 7 bzw. 8 montiert sind. Insbesondere sind Paare von parallel zueinander verlaufenden, zweiten Bandelementen 28 vorgesehen, deren Abstand im Wesentlichen der in Umfangsrichtung der Luftdrosselspule 1 verlaufenden Dicke 33 der Sternarme 7, 8 entspricht, wie dies am besten aus Fig. 6 ersichtlich ist.

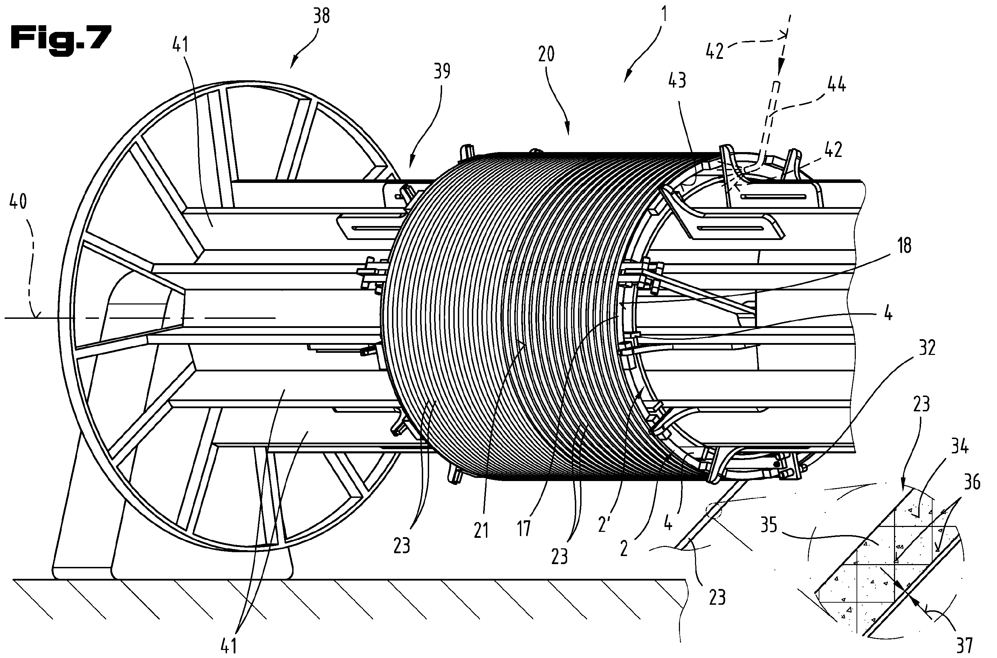

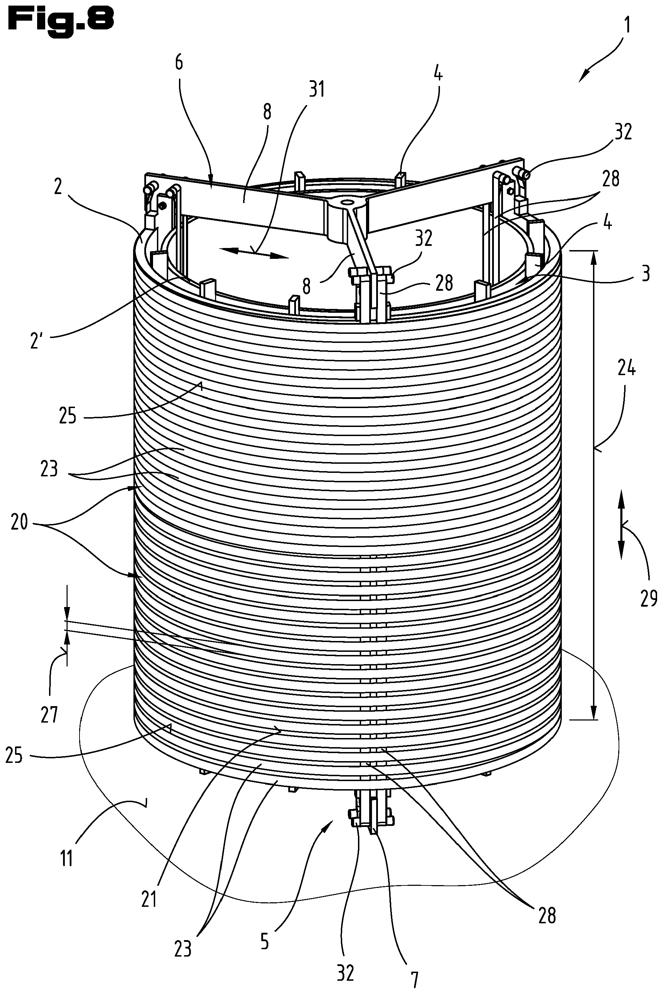

Wie weiters aus Fig. 6, aber auch aus Fig. 7 und 8 ersichtlich ist, kann auch vorgesehen sein, dass das zumindest eine erste Bandelement 23 zumindest innerhalb von Teilabschnitten der axialen Höhe 24 der wenigstens einen Wicklungslage 2-2‴ in Axialrichtung - Pfeil 29 - zueinander axial distanziert gewickelt ist. Dementsprechend sind zwischen den einzelnen Windungen des ersten Bandelementes 23 jeweils Freiräume vorgesehen, innerhalb welcher die isolierende Mantelfläche 21 bzw. die Wicklungsisolation der jeweiligen Wicklungslage 2-2‴ zum Vorschein kommt bzw. zugreifbar ist. Damit kann vor allem die erforderliche Menge an erstem Bandmaterial 23 reduziert werden und dennoch eine ausreichende Ableitung von Oberflächenladungen erzielt werden, insbesondere im Zusammenwirken mit dem zumindest einen zweiten, axial verlaufenden Bandelement 28. Dementsprechend kann die Mantelfläche 21 der Luftdrosselspule 1 auch mit einer gitterartigen Struktur aus ersten und zweiten Bandelementen 23, 28 versehen bzw. beschichtet sein.

Wie am besten aus Fig. 7 ersichtlich ist, kann das zumindest eine erste und/oder zweite Bandelement 23, 28 ein Gewebe 34 oder ein Gewirk aus Textil-, Glas- und/oder Kunststofffasern umfassen. Dieses Gewebe 34 bzw. Gewirk ist mit Kunstharz 35 und darin dispergiertem, leitfähigen Partikeln 36 versehen. Vor allem durch das Mengenverhältnis zwischen Kunstharz 35 und darin dispergierten leitfähigen Partikeln 36 kann die elektrische Leitfähigkeit des ersten und/oder zweiten Bandelementes 23, 28 den jeweiligen Erfordernissen angepasst werden. Zweckmäßig ist es dabei, wenn das zumindest eine erste und/oder zweite Bandelement 23, 28 eine Dicke 37 zwischen 0,1 mm bis 1,0 mm, vorzugsweise zwischen 0,2 mm und 0,3 mm aufweist. Dadurch kann eine ausreichende Robustheit und Zugfestigkeit bzw. Dehnungsfestigkeit des ersten bzw. zweiten Bandelementes 23, 28 sichergestellt werden. Dennoch wird dadurch eine übermäßige Dicke der Ladungsableitungsschicht 20 vermieden.

In den Fig. 7, 8 ist ein zweckmäßiger Herstellungsvorgang zur Schaffung einer Luftdrosselspule 1 bzw. eines diesbezüglichen Halbfabrikats veranschaulicht. Dabei wird mittels einer Wickelvorrichtung 38, welche einen drehbar gelagerten Wickelkörper 39 umfasst, wenigstens eine hohlzylindrische Wicklungslage 2, 2` bereitgestellt bzw. hergestellt. Das dargestellte Beispiel zeigt zwei hohlzylindrische Wicklungslagen 2, 2` zwischen denen axial verlaufende Spaltleisten 4 angeordnet sind.

Der Wickelkörper 39 der Wickelvorrichtung 38 ist beispielsgemäß um eine horizontal verlaufende Drehachse 40 drehbar. Der Wickelkörper 39 ist steuerungstechnisch kontrolliert antreibbar. Der Wickelkörper 39 umfasst eine Mehrzahl von parallel zu seiner Drehachse 40 verlaufende, in einem vorbestimmten radialen Abstand zur Drehachse 40 beabstandete, in Bezug auf einen Kreisumfang verteilt angeordnete Stützelemente 41.

Mittels der Wickelvorrichtung 38 bzw. dem drehbar gelagertem Wickelkörper 39 wird zumindest eine hohlzylindrische Wicklungslage 2, 2` produziert, wobei der elektrische Leiterdraht 17 dieser zumindest einen hohlzylindrischen Wicklungslage 2, 2` mitsamt seiner mantelseitigen Isolationsschicht 18 wendelförmig um die Spulenachse 14 der herzustellenden Luftdrosselspule 1, welche Spulenachse 14 mit der Drehachse 40 übereinstimmt, gewickelt wird. Der entsprechende Wickel- und Produktionsprozess für solche Luftdrosselspulen 1 ist beispielsweise aus der AT501074A1, welche auf die Anmelderin zurückgeht, bekannt.

Bei der dargestellten Herstellungsphase gemäß Fig. 7 sind die elektrischen Kernkomponenten, insbesondere die hohlzylindrischen Wicklungslagen 2, 2` mittels der Wickelvorrichtung 38 bereits erstellt. Bei dem in vollen Linien dargestellten Verfahrensschritt wird die radial äußere hohlzylindrische Wicklungslage 2 an ihrer äußeren Mantelfläche 21 mit der Ladungsableitungsschicht 20 versehen bzw. beschichtet. In strichlierten Linien ist außerdem ein späterer bzw. nachfolgender Verfahrensschritt veranschaulicht, nämlich das Auf- bzw. Einbringen eines Stabilisierungsharzes 42 zum Stabilisieren der zumindest einen hohlzylindrischen Wicklungslage 2, 2'. Nach einer gewissen Erhärtung oder Aushärtung des Stabilisierungsharzes 42 liegt ein in sich formbeständiges Wicklungspaket vor und können die hohlzylindrischen Wicklungslagen 2, 2` von der Wickelvorrichtung 38 bzw. vom Wickelkörper 39 abgenommen werden.

Die Ladungsableitungsschicht 20 wird dabei durch ein in Bezug auf die Spulenachse 14 bzw. in Bezug auf die Drehachse 40 des Wickelkörpers 39 wendelförmiges Umwickeln der Mantelfläche 21 der zumindest einen bzw. äußeren hohlzylindrischen Wicklungslage 2 hergestellt. Hierfür wird zumindest ein erstes Bandelement 23 eingesetzt, welches zumindest eine erste Bandelement 23 eine vorbestimmte, elektrische Leitfähigkeit aufweist. Die vorbestimmte, elektrische Leitfähigkeit dieses zumindest einen ersten Bandelementes 23 ist dabei deutlich geringer, insbesondere um den Faktor 10¹⁵ bis 10²⁰ geringer als die elektrische Leitfähigkeit des wendelförmig gewickelten, elektrischen Leiterdrahtes 17. Die vorbestimmte elektrische Leitfähigkeit des zumindest einen ersten Bandelementes 23 ist jedoch deutlich höher, insbesondere um den Faktor 10² bis 10⁷ höher, als die elektrische Leitfähigkeit der mantelseitigen Isolationsschicht 18 des Leiterdrahtes 17. Insbesondere wird durch Umwickeln der zuvor bereitgestellten, radial äußeren Wicklungslage 2 mit einem elektrisch teilweise bzw. beschränkt leitfähigen Bandelement 23 an der äußeren Mantelfläche 21 dieser Wicklungslage 2 eine definierte Ladungsableitungsschicht 20 aufgebaut bzw. mitdefiniert. Diese Ladungsableitungsschicht 20 kann dabei vollflächig bzw. partiell ausgeführt sein oder auch eine Kombination aus vollflächiger und partieller Bedeckung der zumindest eine hohlzylindrischen Wicklungslage 2, 2` umfassen, wie dies in Fig. 7 und 8 beispielhaft veranschaulicht ist.

Vor der Aufbringung des zumindest einen ersten Bandelementes 23 kann entsprechend einem zweckmäßigen Verfahrensschritt auch vorgesehen sein, dass zumindest ein zweites Bandelement 28 wenigstens an der äußeren hohlzylindrischen Wicklungslage 2 angebracht wird. Beispielsgemäß ist dieses zumindest eine zweite Bandelement 28 an der äußeren Mantelfläche 21 der radial äußeren Wicklungslage 2, und auch an der inneren Mantelfläche der inneren bzw. innersten Wicklungslage 2` vorgesehen. Dabei sind jeweils mehrere über den Kreisumfang der Wicklungslage 2, 2` verteilt angeordnete, axial verlaufende, zweite Bandelemente 28 vorgesehen, wie dies am besten aus Fig. 8 ersichtlich ist. Das zumindest eine zweite Bandelement 28 erstreckt sich dabei elektrisch verbindend zwischen dem ersten Wicklungsstern 5 und dem zweiten Wicklungsstern 6. Zumindest einzelne Sternarme 7, 8, beispielsgemäß alle Sternarme 7, 8 der Wicklungsterne 5, 6 sind über jeweils ein Paar aus zweiten Bandelementen 28 in Axialrichtung - Pfeil 29 - zusammengespannt bzw. zusammengehalten. Demnach stellt das zumindest eine zweite Bandelement 28 an mehreren in Kreisumfangsrichtung der Drosselspule 1 voneinander distanzierten Positionen elektrische Verbindungselemente zwischen dem ersten bzw. unteren Wicklungsstern 5 und dem zweiten bzw. oberen Wicklungsstern 6 dar. Zweckmäßig ist es dabei, wenn Paare von zweiten Bandelementen 28 an in Kreisumfangsrichtung einander gegenüberliegenden Seiten der Sternarme 7, 8 der Wicklungssterne 5, 6 verankert bzw. montiert sind. Die zweiten Bandelemente 28 liegen dabei vorzugsweise direkt an der äu-ßeren Mantelfläche 21 bzw. an der inneren Mantelfläche 43 der Wicklungslagen 2, 2' an bzw. auf.

Ein vor dem ersten Bandelement 23 auf die zumindest eine hohlzylindrische Wicklungslage 2 aufgebrachtes, zweites Bandelement 28 wird nachfolgend vom wendelförmig aufgebrachten, ersten Bandelement 23 zumindest teilweise umwickelt bzw. gegen die Mantelfläche 21 gedrängt. Insbesondere werden das erste, wendelförmig verlaufende Bandelement 23 und das zweite, sich axial und im Wesentlichen geradlinig erstreckende Bandelement 28 an mehreren in Axialrichtung verlaufenden Positionen einander überkreuzt. Insbesondere werden eine Vielzahl von gegenseitigen Kontaktierungs- bzw. Überkreuzungsstellen 30 zwischen dem wenigsten einen ersten Bandelement 23 und dem wenigstens einen zweiten Bandelement 28 geschaffen. Dies gibt eine zuverlässige elektrische Kontaktierung zwischen den genannten Bandelementen 23, 28 und in weiterer Folge durch die Kopplung des zumindest einen zweiten Bandelementes 28 mit den Wicklungsstemen 5, 6 bzw. deren Sternarmen 7, 8 eine zuverlässige elektrische Verbindung. Das wendelförmig verlaufende erste bzw. das axial verlaufende zweite Bandelement 23, 28 können Abmessungen und/oder Materialeigenschaften entsprechend den vorhergehenden Beschreibungsteilen aufweisen.

Um eine in sich kompakte Luftdrosselspule 1 zu schaffen, ist ein Vorgehen zweckmäßig, bei welchem die zumindest eine hohlzylindrische Wicklungslage 2, 2` und/oder das zumindest eine erste und/oder zweite Bandelement 23, 28 nach dessen Aufwickeln bzw. Aufbringen auf die Wicklungslage 2, 2` aufgeheizt werden und auf ein vorbestimmtes Temperaturniveau verbracht werden. Dabei wird erreicht, dass das Kunstharz 35 an oder in dem zumindest einen ersten und/oder zweiten Bandelement 23, 28 chemisch bzw. physikalisch reagiert und dabei das erste und/oder das zweite Bandelement 23 untereinander und/oder mit der äußeren Mantelfläche 21 respektive mit der Wicklungsisolation bzw. mit der Isolationsschicht 18 der Leiterdrähte 17 verklebt wird. Dadurch wird ein in sich stabiler und kompakter Verbund aus den Bandelementen 23, 28, aus der Isolationsschicht 18 im Mantelbereich der Leiterdrähte 17 und aus den Leiterdrähten 17 geschaffen.

Wie ebenso aus den Fig. 7, 8 ersichtlich ist, kann das zumindest eine erste Bandelement 23 zumindest innerhalb von axial verlaufenden Teilabschnitten einer axialen Höhe 24 der zumindest einen hohlzylindrischen Wicklungslage 2, 2` einander überlappend gewickelt sein. Ebenso ist eine lückenlose bzw. spaltfreie, wendelförmige Umwicklung der hohlzylindrischen Wicklungslage 2 mit dem zumindest einen ersten Bandelement 23 denkbar. Dies gibt eine besonders glatte, insbesondere eine in axialer Richtung entweder völlig stufenlose oder nahezu stufenlose Anbringung des zumindest einen ersten wendelförmig verlaufenden Bandelementes 23. Alternativ oder in Kombination dazu ist es auch möglich, das zumindest eine erste Bandelement 23 zumindest innerhalb von axialen Teilabschnitten einer axialen Höhe 24 der zumindest einen hohlzylindrischen Wicklungslage 2 in Axialrichtung - Pfeil 29 - voneinander beabstandet zu wickeln. Eine Kombination beider Wickelschemen ist in Fig. 8 exemplarisch veranschaulicht. Eine stufenlose Anbringung des zumindest einen ersten Bandelementes 23 ist erzielbar, wenn die einzelnen Windungen des zumindest einen ersten Bandelementes 23 in Axialrichtung - Pfeil 29 - weder überlappen, noch zueinander distanziert sind.

Zur Stabilisierung bzw. Verfestigung der Luftdrosselspule 1 kann es zweckmäßig sein, wenn diese mit Stabilisierungsharz 42 versehen wird, wie dies vorstehend bereits dargelegt wurde. Dieses Stabilisierungsharz 42 wird vorzugsweise nach der Anbringung des ersten und/oder zweiten Bandelementes 23, 28 aufgebracht. Das Stabilisierungsharz 42 wird dabei vorzugsweise ausschließlich auf eine innere Mantelfläche 43 der zumindest einen hohlzylindrischen Wicklungslage 2, 2` aufgebracht, insbesondere aufgesprüht. Hierfür kann eine Sprühlanze 44 verwendet werden. Das Aufbringen bzw. Aufsprühen dieses Stabilisierungsharzes 42 erfolgt derart, dass es ausschließlich ausgehend von der inneren Mantelfläche 43 der zumindest einen hohlzylindrischen Wicklungslage 2, 2` aufgebracht wird. Dabei wird die zumindest eine hohlzylindrische Wicklungslage 2, 2', insbesondere deren Isolationsschicht 18, mit dem Stabilisierungsharz 42 getränkt. Dadurch wird sichergestellt, dass die vorbestimmte, elektrische Leitfähigkeit der Ladungsableitungsschicht 20 erhalten bleibt, indem kein Stabilisierungsharz 42 oder nur eine marginale Menge an Stabilisierungsharz 42 auf die Ladungsableitungsschicht 20 bzw. auf die Bandelemente 23 und/oder 28 auftrifft.

Insbesondere wird die zumindest eine Wicklungslage 2, 2` quasi ausgehend von innen mit dem Stabilisierungsharz 42 durchtränkt und kann das Stabilisierungsharz 42 nachfolgend durch Temperatureinwirkung und/oder durch Abwarten der jeweiligen Aushärtungszeit aushärten bzw. verfestigen.

Zweckmäßig ist es, wenn der Vorgang des Verklebens des ersten und/oder zweiten Bandelementes 23, 28 via das Kunstharz 35 zeitlich vor dem Verfahrensschritt des Aufbringens des flüssigen Stabilisierungsharzes 42 auf die innere Mantelfläche 43 der zumindest einen hohlzylindrischen Wicklungslage 2, 2` vorgenommen wird. Dadurch ist sichergestellt, dass das erste und/oder zweite Bandelement 23, 28 in elektrischen Kontakt bleiben können und dennoch gut an der äußeren Mantelfläche 21 anhaften können.

Besonders zweckmäßig ist es, wenn das wendelförmige Aufwickeln des elektrischen Leiterdrahtes 17 mit seiner mantelseitigen Isolationsschicht 18 mittels dem drehbaren, spulenartigen Wickelkörper 39 erfolgt und im Anschluss, vorzugsweise bevor die zumindest eine hohlzylindrische Wicklungslage 2, 2` vom spulenartigen Wickelkörper 39 abgenommen wird, das zumindest eine erste und/oder zweite Bandelement 23, 28 angebracht wird/werden. Insbesondere kann die Wickelvorrichtung 38 bzw. der Wickelkörper 39 in effizienter Art und Weise auch dazu genutzt werden, um vor allem das zumindest eine erste Bandelement 23, gegebenenfalls auch das zumindest eine zweite Bandelement 28, an der zumindest einen hohlzylindrischen Wicklungslage 2, 2` anzubringen. Dies ergibt wesentliche produktionstechnische und wirtschaftliche Vorteile sowie qualitative Effekte.

Das zumindest eine erste Bandelement 23 kann dabei auch mehrlagig ausgeführt bzw. mehrlagig auf die zumindest eine hohlzylindrische Wicklungslage 2, 2` aufgewickelt sein. Ebenso ist eine in Bezug auf die Wicklungsrichtung gegensinnige, zweilagige Schicht aus dem zumindest einen ersten Bandelement 23 als Ladungsableitungsschicht 20 denkbar. Insbesondere können gegenläufige, zusammengesetzte und/oder einstückige erste Bandelemente 23 vorgesehen sein, mit welchen die Ladungsableitungsschicht 20 aufgebaut ist.

Die Ausführungsbeispiele zeigen mögliche Ausführungsvarianten, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt.

Der Schutzbereich ist durch die Ansprüche bestimmt. Die Beschreibung und die Zeichnungen sind jedoch zur Auslegung der Ansprüche heranzuziehen. Einzelmerkmale oder Merkmalskombinationen aus den gezeigten und beschriebenen unterschiedlichen Ausführungsbeispielen können für sich eigenständige erfinderische Lösungen darstellen. Die den eigenständigen erfinderischen Lösungen zugrundeliegende Aufgabe kann der Beschreibung entnommen werden.

Sämtliche Angaben zu Wertebereichen in gegenständlicher Beschreibung sind so zu verstehen, dass diese beliebige und alle Teilbereiche daraus mitumfassen, z.B. ist die Angabe 1 bis 10 so zu verstehen, dass sämtliche Teilbereiche, ausgehend von der unteren Grenze 1 und der oberen Grenze 10 mit umfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1, oder 5,5 bis 10.

Der Ordnung halber sei abschließend darauf hingewiesen, dass zum besseren Verständnis des Aufbaus Elemente teilweise unmaßstäblich und/oder vergrößert und/oder verkleinert dargestellt wurden.

**Bezugszeichenaufstellung**

| | | | |
|---|---|---|---|
| 1 | Luftdrosselspule | 30 | Überkreuzungsstelle |
| | | 31 | Radialrichtung - Pfeil |
| 2 | Wicklungslage | 32 | Haltefortsatz |
| 3 | Luftspalt | 33 | Dicke |
| 4 | Spaltleiste | 34 | Gewebe |
| 5 | Wicklungsstern | 35 | Kunstharz |
| 6 | Wicklungsstern | 36 | Partikel |
| 7 | Sternarm | 37 | Dicke |
| 8 | Sternarm | 38 | Wickelvorrichtung |
| 9 | Stützkonstruktion | 39 | Wickelkörper |
| 10 | Isolator | 40 | Drehachse |
| 11 | Abstützebene | 41 | Stützelement |
| 12 | Stirnende | 42 | Stabilisierungsharz |
| 13 | Stirnende | 43 | Mantelfläche (innere) |
| 14 | Spulenachse | 44 | Sprühlanze |
| 15 | Anschluss | | |
| 16 | Anschluss | | |
| 17 | Leiterdraht | | |
| 18 | Isolationsschicht | | |
| 19 | Spulenende | | |
| 20 | Ladungsableitungsschicht | | |
| 21 | Mantelfläche (äußere) | | |
| 22 | Mantelfläche (innere) | | |
| 23 | Bandelement | | |
| 24 | axiale Höhe | | |
| 25 | Ableitungsoberfläche | | |
| 26 | Überlappungsweite | | |
| 27 | Bandbreite | | |
| 28 | Bandelement | | |
| 29 | Axialrichtung - Pfeil | | |

## Patentansprüche

1. HVDC-Luftdrosselspule (1) mit zumindest zwei elektrischen Anschlüssen (15, 16), umfassend:
- zumindest eine hohlzylindrische Wicklungslage (2 - 2‴) deren elektrischer Leiterdraht (17) mitsamt seiner mantelseitigen Isolationsschicht (18) wendelförmig um eine Spulenachse (14) gewickelt ist,
- eine Ladungsableitungsschicht (20) mit einer vorbestimmten elektrischen Leitfähigkeit, welche Ladungsableitungsschicht (20) zumindest an einer äußeren Mantelfläche (21) der zumindest einen hohlzylindrischen Wicklungslage (2 - 2‴) angebracht ist und mit wenigstens einem der elektrischen Anschlüsse (15, 16) der Luftdrosselspule (1) elektrisch leitfähig verbunden ist,
**dadurch gekennzeichnet, dass**
- die Ladungsableitungsschicht (20) zumindest ein erstes Bandelement (23) aus elektrisch leitfähigem Material umfasst, welches wendelförmig um die Spulenachse (14) verläuft und an der äußeren Mantelfläche (21) der zumindest einen hohlzylindrischen Wicklungslage (2 - 2‴) anliegt,
- und dass das zumindest eine erste Bandelement (23) eine vorbestimmte elektrische Leitfähigkeit aufweist, welche geringer ist als eine elektrische Leitfähigkeit des elektrischen Leiterdrahtes (17), jedoch höher ist als eine elektrische Leitfähigkeit der mantelseitigen Isolationsschicht (18) des Leiterdrahtes (17).

2. Luftdrosselspule nach Anspruch 1, **dadurch gekennzeichnet, dass** die Ladungsableitungsschicht (20) zumindest ein zweites Bandelement (28) aus elektrisch leitfähigem Material umfasst, welches zumindest eine zweite Bandelement (28) in Axialrichtung - Pfeil (29) - der Luftdrosselspule (1) zumindest an der äußeren Mantelfläche (21) der zumindest einen hohlzylindrischen Wicklungslage (2 - 2‴) verläuft, und dass
das zumindest eine erste Bandelement (23) und das zumindest eine zweite Bandelement (28) an mehreren Überkreuzungsstellen (30) einander überkreuzend verlaufen und an diesen Überkreuzungsstellen (30) elektrisch leitfähig miteinander kontaktiert sind.

3. Luftdrosselspule nach Anspruch 2, **gekennzeichnet durch** einen ersten elektrisch leitfähigen Wicklungsstern (5) oder durch mehrere erste Sternarmelemente welcher/welche an einem ersten axialen Stirnende (12) der zumindest einen hohlzylindrischen Wicklungslage (2 - 2‴) angeordnet ist/sind und einen zweiten elektrisch leitfähigen Wicklungsstern (6) oder mehrere zweite Sternarmelemente welcher/welche an einem zweiten axialen Stirnende (13) der zumindest einen hohlzylindrischen Wicklungslage (2 - 2‴) angeordnet ist/sind, wobei das wenigstens eine zweite, axial zur Luftdrosselspule (1) verlaufende Bandelement (28) aus dem elektrisch leitfähigen Material den ersten und zweiten Wicklungsstern (5, 6) oder zumindest einzelne der ersten und zweiten Sternarmelemente mit einer vorbestimmten elektrischen Leitfähigkeit miteinander verbindet.

4. Luftdrosselspule nach Anspruch 3, **dadurch gekennzeichnet, dass** der erste und zweite elektrisch leitfähige Wicklungsstern (5, 6) oder zumindest einzelne der ersten und zweiten Sternarmelemente durch das zumindest eine zweite Bandelement (28) in Axialrichtung - Pfeil (29) - zusammengespannt sind.

5. Luftdrosselspule nach einem der Ansprüche 2 bis 4, **dadurch gekennzeichnet, dass** das wenigstens eine zweite, axial verlaufende Bandelement (28) in radialer Richtung - Pfeil (31) - näher zu der zumindest einen hohlzylindrischen Wicklungslage (2 - 2‴) angeordnet ist, als das zumindest eine wendelförmig verlaufende, erste Bandelement (23).

6. Luftdrosselspule nach einem der Ansprüche 2 bis 5, **dadurch gekennzeichnet, dass** das zumindest eine erste und das zumindest eine zweite Bandelement (23, 28) durch identische Bandmaterialen gebildet sind.

7. Luftdrosselspule nach einem der vorhergehenden Ansprüche, **dadurch gekennzeichnet, dass** das elektrisch leitfähige Material der Ladungsableitungsschicht (20) einen Oberflächenwiderstand im Bereich von 10⁷ bis 10¹² Ohm/Quadrat, insbesondere im Bereich von 10⁸ bis 10¹⁰ Ohm/Quadrat aufweist.

8. Luftdrosselspule nach einem der Ansprüche 3 bis 7, **dadurch gekennzeichnet, dass** zumindest ein Sternarm (7, 8) des ersten und/oder zweiten Wicklungssterns (5, 6), oder wenigstens ein Haltefortsatz (32) an zumindest einem der Wicklungssterne (5, 6), oder wenigstens ein Haltefortsatz (32) an wenigstens einem der ersten und zweiten Sternarmelemente von dem wenigstens einen zweiten Bandelement (28) zumindest partiell umschlungen ist.

9. Luftdrosselspule nach einem der vorhergehenden Ansprüche, **dadurch gekennzeichnet, dass** das zumindest eine erste Bandelement (23) zumindest innerhalb von Teilabschnitten einer axialen Höhe (24) der wenigstens einen hohlzylindrischen Wicklungslage (2 - 2‴) in Axialrichtung - Pfeil (29) - überlappend gewickelt ist.

10. Luftdrosselspule nach einem der vorhergehenden Ansprüche, **dadurch gekennzeichnet, dass** das zumindest eine erste Bandelement (23) zumindest innerhalb von Teilabschnitten einer axialen Höhe (24) der wenigstens einen hohlzylindrischen Wicklungslage (2 - 2‴) in Axialrichtung - Pfeil (29) - distanziert gewickelt ist.

11. Luftdrosselspule nach einem der vorhergehenden Ansprüche, **dadurch gekennzeichnet, dass** das zumindest eine erste und/oder das zumindest eine zweite Bandelement (23, 28) ein Gewebe (34) oder Gewirk aus Textil-, Glas- oder Kunststofffasern umfasst, welches Gewebe (34) oder Gewirk mit Kunstharz (35) und darin dispergierten, leitfähigen Partikeln (36) versehen ist.

12. Luftdrosselspule nach einem der vorhergehenden Ansprüche, **dadurch gekennzeichnet, dass** das zumindest eine erste und/oder das zumindest eine zweite Bandelement eine Dicke (37) zwischen 0,1 mm bis 1,0 mm, vorzugsweise zwischen 0,2 mm bis 0,3 mm aufweist.

13. Verfahren zur Herstellung einer HVDC-Luftdrosselspule (1) ausgebildet nach einem der vorhergehenden Ansprüche, umfassend die Verfahrensschritte:
- Bereitstellen zumindest einer hohlzylindrischen Wicklungslage (2 - 2` ") deren elektrischer Leiterdraht (17) mitsamt seiner mantelseitigen Isolationsschicht (18) wendelförmig um eine Spulenachse (14) gewickelt ist,
- Anbringen einer Ladungsableitungsschicht (20) an der äußeren Mantelfläche (21) der zumindest einen hohlzylindrischen Wicklungslage (2 - 2'"), welche Ladungsableitungsschicht (20) durch in Bezug auf die Spulenachse (14) wendelförmiges Umwickeln der zumindest einen hohlzylindrischen Wicklungslage (2 - 2` ") mit zumindest einem ersten Bandelement (23) gebildet oder mitdefiniert wird, welches zumindest eine erste Bandelement (23) eine vorbestimmte elektrische Leitfähigkeit aufweist, welche vorbestimmte elektrische Leitfähigkeit des zumindest einen ersten Bandelelementes (23) geringer ist als eine elektrische Leitfähigkeit des elektrischen Leiterdrahtes (17), jedoch höher ist als eine elektrische Leitfähigkeit der mantelseitigen Isolationsschicht (18) des Leiterdrahtes (17).

14. Verfahren nach Anspruch 13, **gekennzeichnet durch** Anbringen von zumindest einem axial - Pfeil (29) - zur zumindest einen hohlzylindrischen Wicklungslage (2 - 2` ") verlaufenden, zweiten Bandelement (28) aus elektrisch leitfähigem Material an der äußeren Mantelfläche (21) der zumindest einen hohlzylindrischen Wicklungslage (2 - 2‴).

15. Verfahren nach Anspruch 14, **gekennzeichnet durch** Anbringen des zumindest einen zweiten Bandelementes (28) zeitlich vor dem Umwickeln der zumindest einen hohlzylindrischen Wicklungslage (2 - 2‴) mit dem zumindest einen ersten Bandelement (23), wobei das zumindest eine erste Bandelement (23) und das zumindest eine zweite Bandelement (28) an mehreren Überkreuzungsstellen (30) einander direkt überkreuzend angebracht und dadurch elektrisch miteinander kontaktiert werden.

16. Verfahren nach einem der Ansprüche 13 bis 15, **gekennzeichnet durch** Bereitstellen von dem zumindest einen ersten und/oder zweiten Bandelement (23, 28) mit einer Breite (27) zwischen 1 cm und 40 cm, vorzugsweise zwischen 2 cm und 10 cm, und einer Dicke (37) zwischen 0,1 mm und 1,0 mm, vorzugsweise zwischen 0,2 mm bis 0,3 mm.

17. Verfahren nach einem der Ansprüche 13 bis 16, **gekennzeichnet durch** Bereitstellen von dem zumindest einen ersten und/oder zweiten Bandelement (23, 28) in Form eines mit Kunstharz (35) getränkten oder beschichteten Gewebes (34) oder Gewirkes, bei welchem das Kunstharz (35) einen pastösen bis festen, bei Raumtemperatur nicht-fließenden, teilvernetzten Zustand aufweist.

18. Verfahren nach einem der Ansprüche 14 bis 17, **gekennzeichnet durch** Anbringen von je einem Wicklungsstern (5, 6) oder von mehreren Sternarmelementen an jedem axialen Stirnende (12, 13) der zumindest einen hohlzylindrischen Wicklungslage (2 - 2‴) und durch elektrisches Kontaktieren des zumindest einen zweiten, axial verlaufenden Bandelementes (28) mit wenigstens einem der beiden Wicklungssterne (5, 6) oder mit axial voneinander distanzierten Sternarmelementen.

19. Verfahren nach einem der Ansprüche 13 bis 18, **gekennzeichnet durch** Aufheizen der zumindest einen hohlzylindrischen Wicklungslage (2 - 2‴) und/oder des zumindest einen ersten und/oder zweiten Bandelementes nach dessen Aufwickeln respektive Anbringen an der zumindest einen hohlzylindrischen Wicklungslage (2 - 2‴), sodass Kunstharz (35) an oder in dem zumindest einen ersten und/oder zweiten Bandelement (23, 28) reagiert und dabei das erste und/oder das zweite Bandelement (23, 28) untereinander und/oder mit der äußeren Mantelfläche (21) respektive mit einer Wicklungsisolation der zumindest einen hohlzylindrischen Wicklungslage (2 - 2‴) verklebt werden.

20. Verfahren nach einem der Ansprüche 13 bis 19, **dadurch gekennzeichnet, dass** das zumindest eine erste Bandelement (23) zumindest innerhalb von Teilabschnitten einer axialen Höhe (24) der zumindest einen hohlzylindrischen Wicklungslage (2 - 2‴) in Axialrichtung - Pfeil (29) - einander überlappend gewickelt wird.

21. Verfahren nach einem der Ansprüche 13 bis 20, **dadurch gekennzeichnet, dass** das zumindest eine erste Bandelement (23) zumindest innerhalb von Teilabschnitten einer axialen Höhe (24) der zumindest einen hohlzylindrischen Wicklungslage (2 - 2‴) in Axialrichtung - Pfeil (29) - voneinander beabstandet gewickelt wird.

22. Verfahren nach einem der Ansprüche 13 bis 21, **gekennzeichnet durch** Aufbringen eines im seinem Verarbeitungszustand fließfähigen, nachfolgend verfestigbaren Stabilisierungsharzes (42) ausschließlich auf eine innere Mantelfläche (22, 43) der zumindest einen hohlzylindrischen Wicklungslage (2 - 2‴), sodass die mantelseitige Isolationsschicht (18) des elektrischen Leiterdrahtes (17) ausschließlich ausgehend von der inneren Mantelfläche (22, 43) der zumindest einen hohlzylindrischen Wicklungslage (2 - 2‴) mit dem Stabilisierungsharz (42) für die zumindest eine hohlzylindrische Wicklungslage (2 - 2‴) getränkt wird.

23. Verfahren nach Anspruch 19 und 22, **dadurch gekennzeichnet, dass** der Verfahrensschritt des Verklebens des ersten und/oder zweiten Bandelementes (22, 28) zeitlich vor dem Verfahrensschritt des Aufbringens des flüssigen Stabilisierungsharzes (42) auf die innere Mantelfläche (22, 43) der zumindest einen hohlzylindrischen Wicklungslage (2 - 2‴) vorgenommen wird.

24. Verfahren nach einem der Ansprüche 13 bis 23, **gekennzeichnet durch** wendelförmiges Aufwickeln des elektrischen Leiterdrahtes (17) auf einen drehbaren, spulenartigen Wickelköper (39) zur Ausbildung der zumindest einen hohlzylindrischen Wicklungslage (2 - 2‴) und durch wendelförmiges Aufwickeln des zumindest einen ersten Bandelementes (23) auf die zumindest eine hohlzylindrische Wicklungslage (2 - 2‴) noch bevor diese vom spulenartigen Wickelkörper (39) abgenommen wird.

## Claims

1. An HVDC air-core reactor (1) with at least two electrical connections (15, 16), comprising:
- at least one hollow-cylindrical winding layer (2-2‴), the conductor wire (17) of which is helically wound about a coil axis (14) along with its jacket-side insulation layer (18),
- a charge dissipating layer (20) with a predetermined electrical conductivity, which charge dissipating layer (20) is applied at least to an outer lateral surface (21) of the at least one hollow-cylindrical winding layer (2-2‴) and is connected in an electrically conductive manner to at least one of the electrical connections (15, 16) of the air-core reactor (1),
**characterized in that**
- the charge dissipating layer (20) comprises at least one first tape element (23) of electrically conductive material, which extends helically around the coil axis (14) and abuts on the outer lateral surface (21) of the at least one hollow-cylindrical winding layer (2-2‴),
- and that the at least one first tape element (23) has a predetermined electrical conductivity, which is lower than an electrical conductivity of the electrical conductor wire (17) while still being higher than an electrical conductivity of the jacket-side insulation layer (18) of the conductor wire (17).

2. The air-core reactor according to claim 1, **characterized in that** the charge dissipating layer (20) comprises at least one second tape element (28) of electrically conductive material, which at least one second tape element (28) extends in the axial direction - arrow (29) - of the air-core reactor (1) at least on the outer lateral surface (21) of the at least one hollow-cylindrical winding layer (2-2‴), and that
the at least one first tape element (23) and the at least one second tape element (28) extend so as to cross over one another at multiple crossover points (30) and are contacted to one another in an electrically conductive manner at these crossover points (30).

3. The air-core reactor according to claim 2, **characterized by** a first electrically conductive winding star (5) or by multiple first star arm elements, which is/are arranged on a first axial end face (12) of the at least one hollow-cylindrical winding layer (2-2‴), and a second electrically conductive winding star (6) or multiple second star arm elements which is/are arranged on a second axial end face (13) of the at least one hollow-cylindrical winding layer (2-2‴), wherein the at least one second tape element (28) made of the electrically conductive material and extending axially to the air-core reactor (1) connects the first and second winding star (5, 6) or at least individual ones of the first and second star arm elements with a predetermined electrical conductivity.

4. The air-core reactor according to claim 3, **characterized in that** the first and second electrically conductive winding star (5, 6) or at least individual ones of the first and second star arm elements are clamped together in the axial direction - arrow (29) - by means of the at least one second tape element (28).

5. The air-core reactor according to one of claims 2 to 4, **characterized in that** the at least one second axially extending tape element (28) is arranged closer to the at least one hollow-cylindrical winding layer (2-2‴) in the radial direction - arrow (31) - than the at least one helically extending first tape element (23).

6. The air-core reactor according to one of claims 2 to 5, **characterized in that** the at least one first and the at least one second tape element (23, 28) are formed by identical tape materials.

7. The air-core reactor according to one of the preceding claims, **characterized in that** the electrically conductive material of the charge dissipating layer (20) has a surface resistivity in the range of 10⁷ to 10¹² ohm/square, in particular in the range of 10⁸ to 10¹⁰ ohm/square.

8. The air-core reactor according to one of claims 3 to 7, **characterized in that** at least one star arm (7, 8) of the first and/or second winding star (5, 6), or at least one holding projection (32) on at least one of the winding stars (5, 6), or at least one holding projection (32) on at least one of the first and second star arm elements is at least partially wrapped by the at least one second tape element (28).

9. The air-core reactor according to one of the preceding claims, **characterized in that** the at least one first tape element (23) is wound so as to overlap in the axial direction - arrow (29) - at least in partial sections of an axial height (24) of the at least one hollow-cylindrical winding layer (2-2‴).

10. The air-core reactor according to one of the preceding claims, **characterized in that** the at least one first tape element (23) is wound so as to be distanced in the axial direction - arrow (29) - at least in partial sections of an axial height (24) of the at least one hollow-cylindrical winding layer (2-2‴).

11. The air-core reactor according to one of the preceding claims, **characterized in that** the at least one first and/or second tape element (23, 28) comprises a woven fabric (34) or knitted fabric of textile fibers, glass fibers, and/or plastic fibers, which woven fabric (34) or knitted fabric is provided with synthetic resin (35) and conductive particles (36) dispersed therein.

12. The air-core reactor according to one of the preceding claims, **characterized in that** the at least one first and/or second tape element has a thickness (37) of between 0.1 mm and 1.0 mm, preferably between 0.2 mm and 0.3 mm.

13. A method for producing an HVDC air-core reactor (1) formed according to one of the preceding claims, comprising the method steps:
- providing at least one hollow-cylindrical winding layer (2-2" '), the electrical conductor wire (17) of which is helically wound about a coil axis (14) along with its jacket-side insulation layer (18),
- applying a charge dissipating layer (20) to the outer lateral surface (21) of the at least one hollow-cylindrical winding layer (2-2‴), which charge dissipating layer (20) is formed or defined by winding at least one first tape element (23) around the at least one hollow-cylindrical winding layer (2-2‴) in a helical manner with respect to the coil axis (14), which at least one first tape element (23) has a predetermined electrical conductivity, which predetermined electrical conductivity of the at least one first tape element (23) is lower than an electrical conductivity of the electrical conductor wire (17) while still being higher than an electrical conductivity of the jacket-side insulation layer (18) of the conductor wire (17).

14. The method according to claim 13, **characterized by** applying at least one second tape element (28) made of electrically conductive material and extending axially - arrow (29) - to the at least one hollow-cylindrical winding layer (2-2‴) to the outer lateral surface (21) of the at least one hollow-cylindrical winding layer (2-2‴).

15. The method according to claim 14, **characterized by** applying the at least one second tape element (28) chronologically before the at least one first tape element (23) is wound around the at least one hollow-cylindrical winding layer (2-2‴), wherein the at least one first tape element (23) and the at least one second tape element (28) is applied so as to directly cross over one another at multiple crossover points (30) and are thereby made to electrically contact one another.

16. The method according to one of claims 13 to 15, **characterized by** providing the at least one first and/or second tape element (23, 28) with a width (27) of between 1 cm and 40 cm, preferably between 2 cm and 10 cm, and a thickness (37) of between 0.1 mm and 1.0 mm, preferably between 0.2 mm and 0.3 mm.

17. The method according to one of claims 13 to 16, **characterized by** providing the at least one first and/or second tape element (23, 28) in the form of a woven fabric (34) or knitted fabric impregnated with synthetic resin (35), in which the synthetic resin (35) has a partially crosslinked state that is pasty to solid, not fluid at room temperature.

18. The method according to one of claims 14 to 17, **characterized by** applying one winding star (5, 6) or multiple star arm elements at each axial end face (12, 13) of the at least one hollow-cylindrical winding layer (2-2‴) and by electrically contacting the at least one second axially extending tape element (28) with at least one of the two winding stars (5, 6) or with axially distanced star arm elements.

19. The method according to one of claims 13 to 18, **characterized by** heating the at least one hollow-cylindrical winding layer (2-2‴) and/or the at least one first and/or second tape element after it has been wound on or applied to the at least one hollow-cylindrical winding layer (2-2‴), so that synthetic resin (35) on or in the at least one first and/or second tape element (23, 28) reacts and, in this process, the first and/or the second tape element (23, 28) are adhered to one another and/or to the outer lateral surface (21) or to a winding insulation of the at least one hollow-cylindrical winding layer (2-2‴).

20. The method according to one of claims 13 to 19, **characterized in that** the at least one first tape element (23) is wound so as to overlap in the axial direction - arrow (29) - at least in partial sections of an axial height (24) of the at least one hollow-cylindrical winding layer (2-2‴).

21. The method according to one of claims 13 to 20, **characterized in that** the at least one first tape element (23) is wound so as to be mutually distanced in the axial direction - arrow (29) - at least in partial sections of an axial height (24) of the at least one hollow-cylindrical winding layer (2-2‴).

22. The method according to one of claims 13 to 21, **characterized by** applying a stabilizing resin (42) that, in its processing state, is fluid and can subsequently be cured, only to an inner lateral surface (22, 43) of the at least one hollow-cylindrical winding layer (2-2‴), so that the jacket-side insulation layer (18) of the electrical conductor wire (17) is impregnated with the stabilizing resin (42) for the at least one hollow-cylindrical winding layer (2-2‴) only originating from the inner lateral surface (22, 43) of the at least one hollow-cylindrical winding layer (2-2‴).

23. The method according to claim 19 and 22, **characterized in that** the method step of adhering the first and/or second tape element (22, 28) is carried out chronologically before the method step of applying the liquid stabilizing resin (42) to the inner lateral surface (22, 43) of the at least one hollow-cylindrical winding layer (2- 2‴).

24. The method according to one of claims 13 to 23, **characterized by** helically winding the electrical conductor wire (17) onto a rotatable, coil-like winding body (39) for forming the at least one hollow-cylindrical winding layer (2-2‴) and by helically winding the at least one first tape element (23) onto the at least one hollow-cylindrical winding layer (2-2‴) even before it is taken off the winding body (39).

## Revendications

1. Bobine de self-induction à air HVDC (1) avec au moins deux raccordements électriques (15, 16), comprenant :
- au moins une couche d'enroulement cylindrique creuse (2 - 2‴) dont le fil conducteur électrique (17) est enroulé en hélice autour d'un axe de bobine (14) avec sa couche d'isolation (18) côté enveloppe,
- une couche de dissipation de charge (20) ayant une conductivité électrique prédéterminée, laquelle couche de dissipation de charge (20) est appliquée au moins sur une surface d'enveloppe extérieure (21) de l'au moins une couche d'enroulement cylindrique creuse (2 - 2‴) et est reliée de manière conductrice d'électricité à au moins l'un des raccordements électriques (15, 16) de la bobine de self-induction à air (1), **caractérisée en ce que**
- la couche de dissipation de charge (20) comprend au moins un premier élément de bande (23) dans un matériau conducteur d'électricité, qui s'étend en forme d'hélice autour de l'axe de bobine (14) et s'applique contre la surface d'enveloppe extérieure (21) de l'au moins une couche d'enroulement cylindrique creuse (2 - 2‴),
- et **en ce que** l'au moins un premier élément de bande (23) présente une conductivité électrique prédéterminée qui est inférieure à une conductivité électrique du fil conducteur électrique (17), mais supérieure à une conductivité électrique de la couche d'isolation (18) du fil conducteur (17) située du côté de l'enveloppe.

2. Bobine de self-induction à air selon la revendication 1, **caractérisée en ce que** la couche de dissipation de charge (20) comprend au moins un deuxième élément de bande (28) en matériau électriquement conducteur, lequel au moins un deuxième élément de bande (28) s'étend dans la direction axiale - flèche (29) -, de la bobine de self-induction à air (1) au moins sur la surface d'enveloppe extérieure (21) de l'au moins une couche d'enroulement cylindrique creuse (2 - 2‴), et **en ce qu'**au moins un premier élément de bande (23) et au moins un deuxième élément de bande (28) s'étendent en se croisant en plusieurs points de croisement (30) et entrent en contact électriquement conducteur l'un avec l'autre à ces points de croisement (30).

3. Bobine de self-induction à air selon la revendication 2, **caractérisée par** une première étoile d'enroulement conductrice électriquement (5) ou par plusieurs premiers éléments de bras d'étoile qui est/sont disposés à une première extrémité frontale axiale (12) de l'au moins une couche d'enroulement cylindrique creuse (2 - 2‴) et par une deuxième étoile d'enroulement électriquement conductrice (6) ou par plusieurs deuxièmes éléments de bras d'étoile qui est/sont disposés à une deuxième extrémité frontale axiale (13) de l'au moins une couche d'enroulement cylindrique creuse (2 - 2‴), dans laquelle l'au moins un deuxième élément de bande (28) en matériau conducteur électriquement, s'étendant axialement par rapport à la bobine de self-induction à air (1), relie entre elles la première et la deuxième étoiles d'enroulement (5, 6) ou au moins certains des premier et deuxième éléments de bras d'étoile avec une conductivité électrique prédéterminée.

4. Bobine de self-induction à air selon la revendication 3, **caractérisée en ce que** la première et la deuxième étoiles d'enroulement conductrices électriquement (5, 6) ou au moins certains des premiers et deuxièmes éléments de bras d'étoile individuels sont serrés ensemble dans la direction axiale, - flèche (29) -, par le au moins un deuxième élément de bande (28).

5. Bobine de self-induction à air selon l'une quelconque des revendications 2 à 4, **caractérisée en ce qu'**au moins le deuxième élément de bande (28) s'étendant axialement est agencé plus près, dans la direction radiale, - flèche (31) -, de ladite au moins une couche d'enroulement cylindrique creuse (2 - 2‴) que ledit au moins un premier élément de bande (23) s'étendant en hélice.

6. Bobine de self-induction à air selon l'une des revendications 2 à 5, **caractérisée en ce que** l'au moins un premier et l'au moins un deuxième éléments de bande (23, 28) sont formés par des matériaux de bande identiques.

7. Bobine de self-induction à air selon l'une des revendications précédentes, **caractérisée en ce que** le matériau électriquement conducteur de la couche de dissipation de charge (20) présente une résistance de surface comprise entre 10⁷ et 10¹² ohms/carré, notamment entre 10⁸ et 10¹⁰ ohms/carré.

8. Bobine de self-induction à air selon l'une des revendications 3 à 7, **caractérisée en ce qu'**au moins un bras d'étoile (7, 8) de la première et/ou de la deuxième étoiles d'enroulement (5, 6) ou au moins un prolongement de maintien (32) sur au moins l'une des étoiles d'enroulement (5, 6), ou au moins un prolongement de maintien (32) sur au moins l'un des premier et deuxième éléments de bras d'étoile est entouré au moins partiellement par le au moins un deuxième élément de bande (28).

9. Bobine de self-induction à air selon l'une des revendications précédentes, **caractérisée en ce que** l'au moins un premier élément de bande (23) est enroulé de manière à se chevaucher dans la direction axiale, - flèche (29) -, au moins à l'intérieur de sections partielles d'une hauteur axiale (24) de l'au moins une couche d'enroulement cylindrique creuse (2 - 2‴).

10. Bobine de self-induction à air selon l'une quelconque des revendications précédentes, **caractérisée en ce que** ledit au moins un premier élément de bande (23) est enroulé à distance dans la direction axiale, - flèche (29) -, au moins à l'intérieur de sections partielles d'une hauteur axiale (24) de l'au moins une couche d'enroulement cylindrique creuse (2 - 2‴).

11. Bobine de self-induction à air selon l'une quelconque des revendications précédentes, **caractérisée en ce que** ledit au moins un premier et/ou ledit au moins un deuxième éléments de bande (23, 28) comprend un tissu (34) ou une maille de fibres textiles, de verre ou de plastique, lequel tissu (34) ou laquelle maille est pourvu(e) d'une résine synthétique (35) et de particules conductrices (36) dispersées dans celle-ci.

12. Bobine de self-induction à air selon l'une quelconque des revendications précédentes, **caractérisée en ce que** ledit au moins un premier et/ou ledit au moins un deuxième éléments de bande présentent une épaisseur (37) comprise entre 0,1 mm et 1,0 mm, de préférence entre 0,2 mm et 0,3 mm.

13. Procédé de fabrication d'une bobine de self-induction à air HVDC (1) réalisée selon l'une des revendications précédentes, comprenant les étapes de procédé suivantes :
- Préparation d'au moins une couche d'enroulement cylindrique creuse (2 - 2‴) dont le fil conducteur électrique (17), y compris sa couche isolante (18) côté enveloppe, est enroulée en hélice autour d'un axe de bobine (14),
- Application d'une couche de dissipation de charge (20) sur la surface d'enveloppe extérieure (21) de l'au moins une couche d'enroulement cylindrique creuse (2 - 2‴), laquelle couche de dissipation de charge (20) est formée ou co-définie par un enroulement en hélice, par rapport à l'axe de bobine (14), de l'au moins une couche d'enroulement cylindrique creuse (2 - 2‴) avec au moins un premier élément de bande (23), ledit au moins un premier élément de bande (23) présentant une conductivité électrique prédéterminée, laquelle conductivité électrique prédéterminée dudit au moins un premier élément de bande (23) étant inférieure à une conductivité électrique du fil conducteur électrique (17), mais supérieure à une conductivité électrique de la couche d'isolation (18) côté enveloppe du fil conducteur (17).

14. Procédé selon la revendication 13, **caractérisé par** la mise en place d'au moins un deuxième élément de bande (28) en matériau électriquement conducteur, s'étendant axialement, - flèche (29) -, par rapport à la au moins une couche d'enroulement cylindrique creuse (2 - 2‴), sur la surface d'enveloppe extérieure (21) de l'au moins une couche d'enroulement cylindrique creuse (2 - 2‴).

15. Procédé selon la revendication 14, **caractérisé par** l'application de l'au moins un deuxième élément de bande (28) avant l'enroulement de l'au moins une couche d'enroulement cylindrique creuse (2 - 2‴) avec l'au moins un premier élément de bande (23), l'au moins un premier élément de bande (23) et l'au moins un deuxième élément de bande (28) étant appliqués de manière à se croiser directement en plusieurs points de croisement (30) et étant ainsi mis en contact électriquement les uns avec les autres.

16. Procédé selon l'une quelconque des revendications 13 à 15, **caractérisé par** la fourniture dudit au moins un premier et/ou deuxième éléments de bande (23, 28) ayant une largeur (27) comprise entre 1 cm et 40 cm, de préférence entre 2 cm et 10 cm, et une épaisseur (37) comprise entre 0,1 mm et 1,0 mm, de préférence entre 0,2 mm et 0,3 mm.

17. Procédé selon l'une des revendications 13 à 16, **caractérisé par** la mise à disposition d'au moins un premier et/ou un deuxième élément des bande (23, 28) sous la forme d'un tissu (34) ou d'une maille imprégné(e) ou enduit(e) de résine synthétique (35), dans lequel la résine synthétique (35) présente un état pâteux à solide qui ne s'écoule pas à température ambiante et est partiellement réticulé.

18. Procédé selon l'une quelconque des revendications 14 à 17, **caractérisé par** la mise en place d'une étoile d'enroulement (5, 6) ou de plusieurs éléments de bras d'étoile à chaque extrémité frontale axiale (12, 13) de ladite au moins une couche d'enroulement cylindrique creuse (2 - 2‴) et par la mise en contact électrique dudit au moins un deuxième élément de bande (28) s'étendant axialement avec au moins l'une des deux étoiles d'enroulement (5, 6) ou avec des éléments de bras d'étoile espacés axialement les uns des autres.

19. Procédé selon l'une quelconque des revendications 13 à 18, **caractérisé par** le chauffage de ladite au moins une couche d'enroulement cylindrique creuse (2-2‴) et/ou dudit au moins un premier et/ou deuxième éléments de bande après son enroulement ou sa mise en place sur ladite au moins une couche d'enroulement cylindrique creuse (2-2‴), de sorte que la résine synthétique (35) réagit sur ou dans l'au moins un premier et/ou un deuxième éléments de bande (23, 28) et en ce que le premier et/ou le deuxième éléments de bande (23, 28) sont alors collés entre eux et/ou avec la surface d'enveloppe extérieure (21) ou avec une isolation d'enroulement de l'au moins une couche d'enroulement cylindrique creuse (2 - 2‴).

20. Procédé selon l'une des revendications 13 à 19, **caractérisé en ce que** le au moins un premier élément de bande (23) est enroulé par chevauchement dans la direction axiale, - flèche (29) -, au moins à l'intérieur de sections partielles de la hauteur axiale (24) de l'au moins une couche d'enroulement cylindrique creuse (2 - 2‴).

21. Procédé selon l'une quelconque des revendications 13 à 20, **caractérisé en ce que** ledit au moins un premier élément de bande (23) est enroulé à distance des autres éléments dans la direction axiale - flèche (29) - au moins à l'intérieur de sections partielles d'une hauteur axiale (24) de ladite au moins une couche d'enroulement cylindrique creuse (2 - 2‴).

22. Procédé selon l'une des revendications 13 à 21, **caractérisé par** l'application d'une résine de stabilisation (42) fluide dans son statut de traitement et pouvant être solidifiée par la suite, exclusivement sur une surface d'enveloppe intérieure (22, 43) de l'au moins une couche d'enroulement cylindrique creuse (2 - 2‴), de sorte que la couche d'isolation (18) côté enveloppe du fil électrique conducteur (17) est imprégnée de la résine de stabilisation (42) pour l'au moins une couche d'enroulement cylindrique creuse (2 - 2‴) exclusivement en partant de la surface d'enveloppe intérieure (22, 43) de l'au moins une couche d'enroulement cylindrique creuse (2 - 2‴).

23. Procédé selon les revendications 19 et 22, **caractérisé en ce que** l'étape de procédé consistant à coller le premier et/ou le deuxième éléments de bande (22, 28) est effectuée temporellement avant l'étape de procédé consistant à appliquer la résine de stabilisation liquide (42) sur la surface d'enveloppe intérieure (22, 43) de ladite au moins une couche d'enroulement cylindrique creuse (2 - 2‴).

24. Procédé selon l'une des revendications 13 à 23, **caractérisé par** l'enroulement en hélice du fil conducteur électrique (17) sur un corps d'enroulement (39) rotatif en forme de bobine pour former l'au moins une couche d'enroulement cylindrique creuse (2 - 2‴) et par l'enroulement hélicoïdal du au moins un premier élément de bande (23) sur l'au moins une couche d'enroulement cylindrique creuse (2 - 2‴) avant même que celle-ci ne soit retirée du corps d'enroulement (39) en forme de bobine.
